# EUROPEAN PATENT SPECIFICATION

(11) **EP 3 794 649 B1**
(45) Date of publication and mention of the grant of the patent: **25.03.2026**
(21) Application number: 19724832.1
(22) Date of filing: 17.05.2019
(51) Int. Cl.: H10N 52/00, H10N 59/00, H10N 52/01

(54) **VERTICAL HALL ELEMENT HAVING REDUCED OFFSET**
VERTIKALES HALLELEMENT MIT REDUZIERTEM OFFSET
ÉLÉMENT À EFFET HALL VERTICAL À DÉCALAGE RÉDUIT

(30) Priority: 18.05.2018 EP 18173349
(43) Date of publication of application: 24.03.2021
(60) Divisional application: 24190841.7
(73) Proprietor: LFoundry S.r.l., 67051 Avezzano (IT)
(72) Inventor: SCHMIDT, Carsten, 67051 Avezzano AQ (IT); SPITZLSPERGER, Gerhard, 67051 Avezzano AQ (IT)
(74) Representative: De Tullio, Michele Elio
(86) International application number: PCT/EP2019/062866
(87) International publication number: WO 2019/219941

(56) References cited:
- US-A- 4 673 964
- US-A1- 2006 170 406
- US-A1- 2012 169 329
- SANDER C ET AL: "Monolithic Isotropic 3D Silicon Hall Sensor", SENSORS AND ACTUATORS A, vol. 247, 27 June 2016 (2016-06-27), pages 587 - 597, XP029713790, ISSN: 0924-4247, DOI: 10.1016/J.SNA.2016.06.038

## Description

### Technical Field

The present invention relates to a vertical Hall element having reduced offset. Also disclosed is a method of manufacturing thereof.

### Background

Magnetic sensor ICs typically use silicon-based Hall elements which are monolithically integrated with the electrical circuits required for signal conditioning and amplification. Typical commercial products with monolithically integrated Hall elements are Hall switch ICs, Hall ICs for linear position measurement, angular position sensor Hall ICs, Hall ICs for current sensing and 3D Hall sensor ICs. Depending on the product type, a Hall IC may include horizontal Hall elements, vertical Hall elements, or both. Vertical Hall elements, which sense the strength of the magnetic field in a direction lying in the plane of the silicon surface, are used in angular position sensor Hall ICs and, together with a horizontal Hall element, in 3D Hall sensor ICs. Conventional vertical Hall elements are formed as follows: a well having n-type conductivity is formed in the low-doped p-type silicon substrate. The n-type well constitutes the Hall plate of the sensor being isolated from the substrate by a p-n junction. Three, four, five or more Hall terminals are formed on the silicon surface within the region of the n-type well, typically arranged in a row or on a circle (R. S. Popovic,"Hall Effect Devices", Institute of Physics Publishing, Bristol and Philadelphia 2004).

In these conventional vertical Hall elements, the sensitivity is limited by the finite depth of the n-type well in which the Hall terminals are placed. For this reason, oftentimes high-voltage CMOS processes having deep wells are used for manufacturing Hall ICs with vertical Hall elements. Even in these processes, well depths are generally only in the order of a several micrometers. Besides low sensitivity, conventional vertical Hall elements typically suffer from high residual offsets. The offset of a Hall element, i.e. the Hall voltage measured at zero magnetic field strength, can be reduced by known techniques such as current spinning, orthogonal coupling or a combination thereof. Effective offset reduction relies on commutation of Hall terminals as well as on the four-fold symmetry of the Hall device. Single conventional vertical Hall elements having their terminals placed all on the same silicon surface deviate necessarily from an ideal four-fold symmetry.

Another disadvantage of a conventional vertical Hall element is its non-linearity. As the n-type Hall plate is formed in the p-type substrate, a depletion zone is formed along the p-n junction during the operation of the Hall element, i.e. when a current is forced through the Hall element. The width of the depletion zone varies spatially and depends on the exact operation condition. In any case, the formation of a depletion region alters the effective resistance of the Hall plate giving rise to a non-linear behavior of the vertical Hall element. The non-linearity makes also the offset cancellation of the Hall element more difficult.

US 2012/169329 A1 discloses a vertical Hall sensor element having a substrate, which has a main surface and a first conductivity type, having an electrically conductive active region of opposite conductivity type which extends from the main surface into the substrate, having upper contact electrodes on the main surface, and having electrically conductive buried layers in the substrate, which contact the active region at lower contact surfaces. Contact plugs provide electrical connection of the buried layers to terminals at the main surface. Alternatively, the buried layers may be exposed toward a rear surface, so that they are directly contactable from the rear surface. A method for measuring a magnetic field with the aid of such a Hall sensor element is also disclosed, in which an electrical measuring current is conducted through the active region between a first upper contact electrode at the main surface and the first lower contact surface. A Hall voltage is picked up in the active region along a path running inclined with respect to a connecting line between the first lower contact surface and the first upper contact electrode. Alternatively, a measuring current is conducted through the active region over such a path, and a Hall voltage is picked up between the first upper contact electrode and the first lower contact surface.

US 2006/170406 A1 discloses a vertical Hall element, wherein an N-type epitaxial layer is formed on a P-type silicon substrate. Four N⁺ regions (diffusion regions used as electrodes) are formed in the N-type epitaxial layer. An insulation layer having a fixed depth is formed around three of the N⁺ regions on a principal surface of the epitaxial layer. The insulation layer restricts a current path region formed between the N⁺ regions. Side surfaces of the N⁺ regions are covered by the insulation layer. The N⁺ regions are brought into contact with the epitaxial layer by a bottom surface exposed from the insulation layer. A further buried N⁺ region is formed at the interface between the epitaxial layer and the substrate, and is connected to the fourth N+ region on the principal surface.

There is a desire to provide a vertical Hall element with improved characteristic parameters, such as an effective offset reduction, a high sensitivity and high degree of linearity.

### Summary

A first embodiment of the vertical Hall element that provides improved characteristic parameters is specified in claim 1. Further embodiments are specified in claims 2 to 13.

According to a possible embodiment of a vertical Hall element, the vertical Hall element comprises a substrate of a first conductivity type having a first surface and a second surface. The vertical Hall element further comprises a well being disposed in the substrate, the well having a second conductivity type. The well is exposed on the second surface of the substrate. The vertical Hall element comprises at least two terminals arranged on the first surface of the substrate and being in contact with the well. The vertical Hall element further comprises at least two terminals arranged on the second surface of the substrate and being in contact with the well.

The at least two terminals on the second surface of the substrate are disposed in an orthogonal projection on the substrate below the at least two terminals on the first surface of the substrate.

According to a possible embodiment of the vertical Hall element, the at least two terminals on the first surface of the substrate comprises a first terminal and a second terminal being arranged next to each other on the first surface of the substrate. The at least two terminals on the second surface of the substrate comprises a third terminal and a fourth terminal being arranged next to each other on the second surface of the substrate. The fourth terminal is located directly below the first terminal such that a virtual straight line between a center of the first terminal and a center of the fourth terminal is perpendicular to first and second surface of the substrate. The third terminal is located directly below the second terminal such that a virtual straight line between a center of the second terminal and a center of the third terminal is perpendicular to first and second surface of the substrate.

According to a possible embodiment of the vertical Hall element, each of the at least two terminals on the first surface of the substrate comprises a shallow and highly doped region extending from the first surface into the substrate, the highly doped region having the second conductivity type. According to a possible embodiment of the vertical Hall element, the vertical Hall element comprises a dielectric layer being disposed on the first surface of the substrate, and a wiring being embedded in the dielectric layer. The at least two terminals on the first surface of the substrate may be connected with a first metal layer of the wiring embedded in the dielectric layer.

According to a possible embodiment of the vertical Hall element, the vertical Hall element comprises a carrier substrate being bonded to a top surface of the dielectric layer. The top surface of the dielectric layer is opposite to a surface of the dielectric layer disposed on the first surface of the substrate.

According to a possible embodiment of the vertical Hall element, each of the at least two terminals on the second surface of the substrate comprises a shallow and highly doped region extending from the second surface into the substrate, the highly doped region having the second conductivity type.

According to a possible embodiment of the vertical Hall element, the vertical Hall element comprises a second dielectric layer and a passivation layer. The second dielectric layer is disposed on the second surface of the substrate and the passivation layer is disposed on the dielectric layer.

According to a possible embodiment of the vertical Hall element, the vertical Hall element comprises a through silicon via filled with a conductive filling that provides a vertical conductive path through the substrate for connecting one of the third and fourth terminal to the wiring in the dielectric layer. The conductive filling of the through silicon via is isolated from the substrate by a dielectric liner disposed onto an inner surface of the through silicon via.

According to a possible embodiment of the vertical Hall element, the vertical Hall element comprises a deep trench isolation structure extending from the first surface of the substrate to the second surface of the substrate so that the well is isolated from the substrate by the deep trench isolation structure.

According to another possible embodiment of the vertical Hall element, the vertical Hall element is configured as a circular vertical Hall element. The well is formed as a ring-shaped well. The vertical Hall element has a plurality of the at least two terminals located on the first surface of the substrate on a first circle and being in contact with the well, and a plurality of the at least two terminals located on the second surface of the substrate on a second circle and in contact with the well. A respective one of the plurality of the at least two terminals on the second surface of the substrate is disposed in an orthogonal projection on the substrate below a respective one of the plurality of the at least two terminals on the first surface of the substrate.

According to a possible embodiment of the vertical Hall element, the vertical Hall element comprises two ring-shaped isolation structures. The two ring-shaped isolation structures extend from the first surface of the substrate to the second surface of the substrate and are concentric with the ring-shaped well so that the well is laterally enclosed by the two ring-shaped isolation structures and isolated from the substrate.

According to a possible embodiment, the vertical Hall element has two terminals on the first surface and two terminals on the second surface of a thinned semiconductor substrate of first conductivity type. The four terminals are arranged such that one terminal on the first surface and one terminal on the second surface each have the same but opposite location. The two terminals on the first surface are formed in a well having the second conductivity type. The well is exposed on the second surface such that also the terminals on the second surface are in contact with the well. The geometry of the vertical Hall element is defined such that the four resistances between the four terminals are nearly equal. The terminals on the second surface are connected by through silicon vias to the wiring on the first surface.

According to another possible embodiment, the vertical Hall element has two terminals on the first surface and two terminals on the second surface of a thinned semiconductor substrate of first conductivity type. The four terminals are arranged such that one terminal on the first surface and one terminal on the second surface each have the same but opposite location. The two terminals on the first surface are formed in a well having the second conductivity type. The well is exposed on the second surface such that also the terminals on the second surface are in contact with the well. The well is enclosed by a deep trench isolation extending from the first surface to the second surface of the thinned semiconductor substrate. The geometry of the vertical Hall element is defined such that the four resistances between the four terminals are nearly equal. The terminals on the second surface are connected by through silicon vias to the wiring on the first surface.

According to another possible embodiment, the vertical Hall element has two terminals on the first surface and two terminals on the second surface of a thinned semiconductor substrate of first conductivity type. The four terminals are arranged such that one terminal on the first surface and one terminal on the second surface each have the same but opposite location. The four terminals are enclosed by a deep trench isolation, which extends from the first surface to the second surface of the thinned semiconductor substrate. The geometry of the vertical Hall sensor is defined such that the four resistances between the four terminals are nearly equal. The terminals on the second surface are connected by through silicon vias to the wiring on the first surface.

According to another possible embodiment, the vertical Hall element has N terminals on the first surface and N terminals on the second surface of a thinned semiconductor substrate of first conductivity type. The N terminals on the first surface have the same size, are equally spaced and are arranged on a circle. The N terminals on the second surface, having also same size, are placed such that for each terminal on the first surface there is one terminal on the second surface having the same but opposite location. The N terminals on the first surface are formed in a ring-shaped well having the second conductivity type. The well is exposed on the second surface such that also the N terminals on the second surface are in contact with the ring-shaped well. The geometry of the vertical Hall element is defined such that the four resistances between the four terminals of each temporary vertical Hall element, that can be formed along the circle, are nearly equal. The N terminals on the second surface are connected by N through silicon vias to the wiring on the first surface.

According to another possible embodiment, the vertical Hall element has N terminals on the first surface and N terminals on the second surface of a thinned semiconductor substrate of first conductivity type. The N terminals on the first surface have same size, are equally spaced and are arranged on a circle. The N terminals on the second surface, having also the same size, are placed such that for each terminal on the first surface there is one terminal on the second surface having the same but opposite location. The N terminals on the first surface are formed in a ring-shaped well having the second conductivity type. The well is exposed on the second surface such that also the N terminals on the second surface are in contact with the ring-shaped well. The ring-shaped well is laterally separated from semiconductor substrate by two deep trench isolation rings. The two deep trench isolation rings extend from first surface to the second surface of the thinned semiconductor substrate. The geometry of the vertical Hall element is defined such that the four resistances between the four terminals of each temporary vertical Hall element, that can be formed along the circle, are nearly equal. The N terminals on the second surface are connected by N through silicon vias to the wiring on the first surface.

According to a possible inventive concept of a vertical Hall element, not according to the present invention, the Hall element comprises a substrate of a first conductivity type having a first surface and a second surface, and a well being disposed in the substrate. The well has a second conductivity type. The vertical Hall element comprises a first terminal, a second terminal, a third terminal and a fourth terminal. Each of the first and third terminal comprises a connecting region. The respective connecting region provides a connection of the first and second terminal to the first surface of the substrate. Each of the first and third terminal is accessed via a doped region extending from the first surface of the substrate inside of the doped region. The second terminal is arranged on the first surface of the substrate. The fourth terminal is arranged on the second surface of the substrate opposite to the second terminal.

According to a possible inventive concept of the vertical Hall element, not according to the present invention, the second terminal comprises a conductive region extending from the first surface of the substrate in the substrate. The fourth terminal comprises a conductive region extending from the second surface of the substrate in the substrate. The fourth terminal is located directly below the second terminal such that a virtual straight line between a center of the conductive region of the second terminal and a center of the conductive region of the fourth terminal is perpendicular to first and second surface of the substrate.

According to a possible embodiment of the vertical Hall element, the vertical Hall element comprises a dielectric layer being disposed on the first surface of the substrate. The vertical Hall element further comprises a carrier being attached to a top surface of the dielectric layer, wherein the top surface of the dielectric layer is opposite to a surface of the dielectric layer disposed on the first surface of the substrate.

According to a possible inventive concept of the vertical Hall element, each of the first and third terminal comprises a conductive buried region buried in the well. The respective connecting region provides a connection of the conductive buried region to the first surface of the substrate.

According to a possible inventive concept of the vertical Hall element, not according to the present invention, the vertical Hall element comprises a first doping well extending form the first surface of the substrate into the well down to the buried region of the first terminal. The vertical Hall element comprises a second doping well extending form the first surface of the substrate into the well down to the buried region of the third terminal.

According to a possible embodiment of the vertical Hall element, the connecting well of the first terminal is surrounded by a first dielectric structure. The connecting well of the third terminal is surrounded by a second dielectric structure.

According to a possible embodiment of the Hall vertical element, the vertical Hall element comprises a deep trench isolation structure extending from the first surface to the second surface of the substrate. The well is isolated by the deep trench isolation structure from the substrate.

A semiconductor device comprising a vertical Hall element of any of the claims is specified in claim 12. The semiconductor device further comprises a circuitry to operate the vertical Hall element, wherein the circuitry is configured as an integrated circuit being formed in the substrate.

According to a possible embodiment of the semiconductor device, the circuitry comprises a bonding pad formed on the second surface of the substrate. The circuitry comprises a through silicon via to provide a connection between the bonding pad and a wiring disposed in dielectric layer on the first surface of the substrate.

Additional features and advantages are set forth in the detailed description that follows and in part will be readily apparent to those skilled in the art from the description or recognized by practising the embodiments as described in the written description and claims hereof, as well as the appended drawings. It is to be understood that both the foregoing general description and the following detailed description are merely exemplary, and are intended to provide an overview or framework to understand the nature and character of the claims.

### Brief Description of the Drawings

The accompanying drawings are included to provide further understanding, and are incorporated in and constitute a part of the specification. The drawings illustrate one or more embodiments, and together with the detailed description serve to explain principles and operation of the various embodiments. As such, the disclosure will become more fully understood from the following detailed description, taken in conjunction with the accompanying figures.
Figures 1 to 7 show a first embodiment of a vertical Hall element;

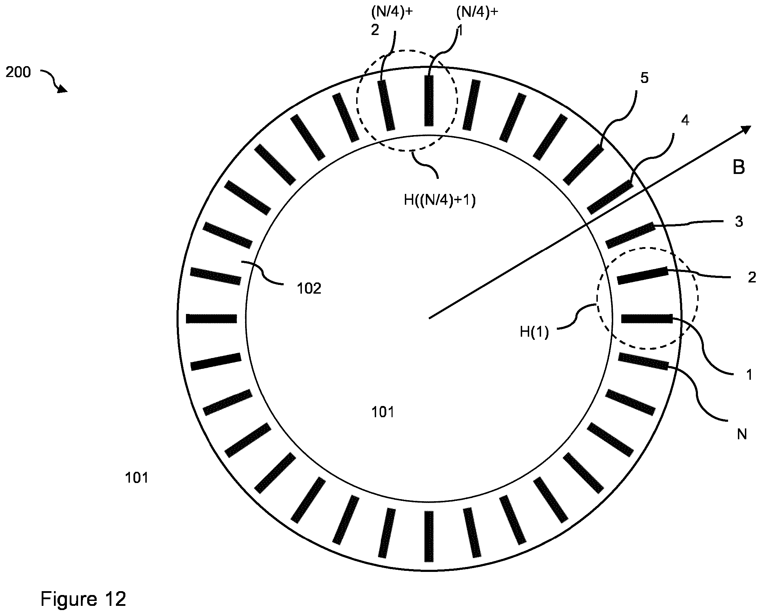

Figures 8 to 14 show modifications of the first embodiment of a vertical Hall element;
Figure 15 shows a first embodiment of a semiconductor device comprising a vertical Hall element;
Figures 16 to 26 illustrate manufacturing steps of a method of manufacturing the first embodiment of a semiconductor device comprising a vertical Hall element;
Figure 27 show a second embodiment of a semiconductor device comprising a vertical Hall sensor;
Figures 28 to 39 illustrate manufacturing steps of a method of manufacturing the second embodiment of a semiconductor device comprising a vertical Hall element;
Figures 40 to 42 show another modification of the first embodiment of a vertical Hall element;
Figures 43 to 49 show a second inventive concept of a vertical Hall element, NOT ACCORDING TO THE PRESENT INVENTION;
Figures 49 to 53 show modifications of the second inventive concept of a vertical Hall element, NOT ACCORDING TO THE PRESENT INVENTION;
Figure 54 show a third embodiment of a semiconductor device comprising a vertical Hall element;
Figures 55 to 65 illustrate manufacturing steps of a method of manufacturing the third embodiment of a semiconductor device comprising a vertical Hall element;
Figure 66 show a fourth embodiment of a semiconductor device comprising a vertical Hall element; and
Figures 67 to 78 illustrate manufacturing steps of a method of manufacturing the fourth embodiment of a semiconductor device comprising a vertical Hall element.

### Detailed description

Reference is now made in detail to various embodiments, examples of which are partly illustrated in the accompanying drawings. Whenever possible, the same or like reference numbers and symbols are used throughout the drawings to refer to the same or like parts. The drawings are not necessary to scale, and one skilled in the art will recognize where the drawings have been simplified to illustrate the key aspects of the disclosure.

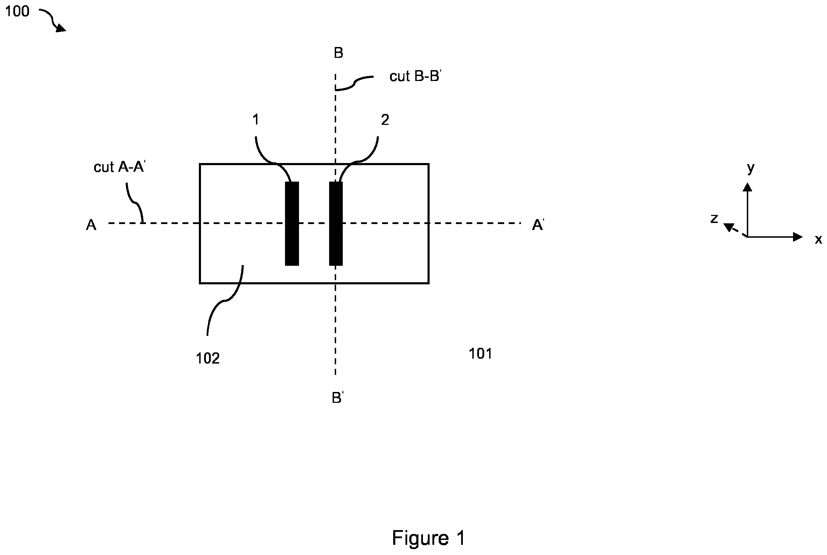

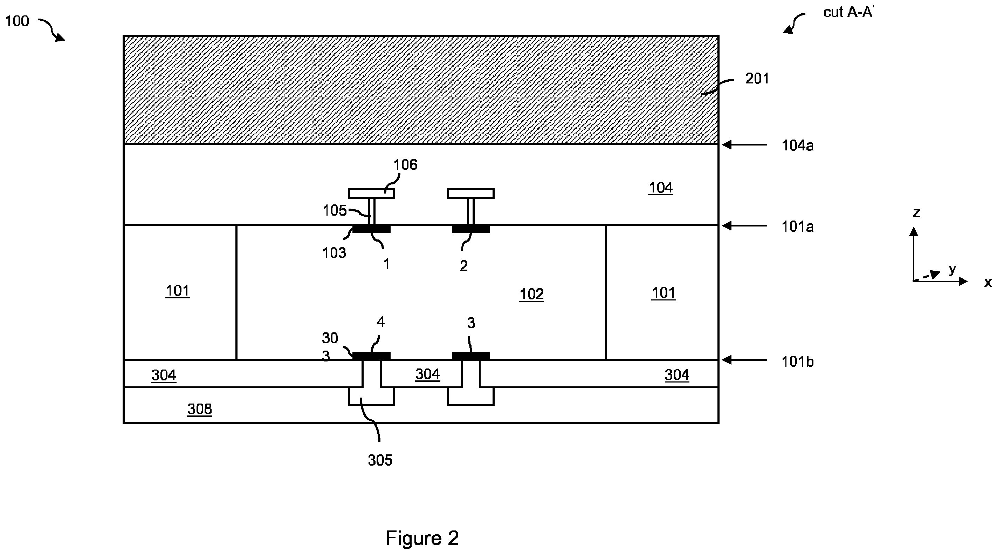

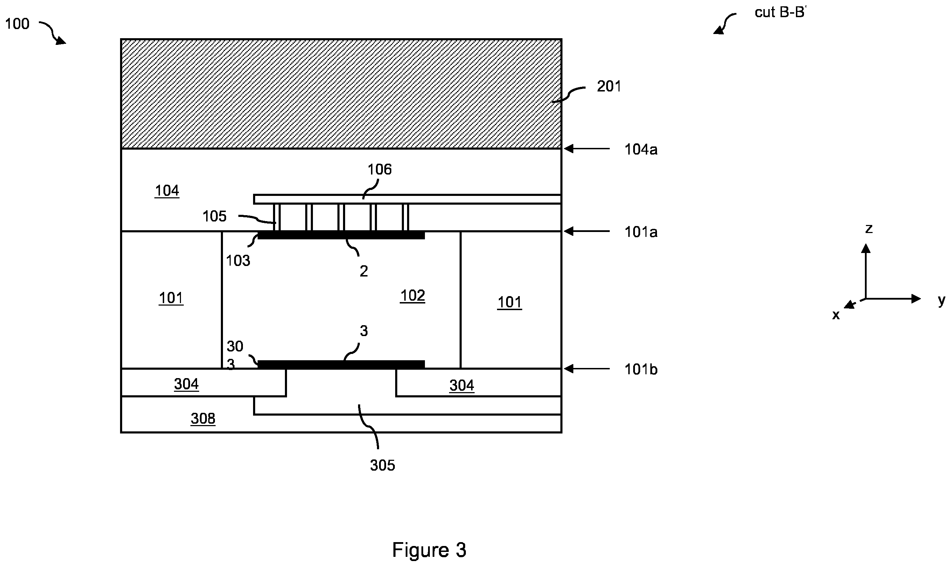

The Fig. 1, 2 and 3 show the vertical Hall element 100. In Fig. 1 the vertical Hall element is shown from above, looking on the first silicon surface. Two cuts are indicated, one cut parallel to the x-direction from A to A', and one cut parallel to the y-direction from B to B'. Fig. 2 shows a cross-section of the vertical Hall element 100 along the cut A- A' and Fig. 3 shows a cross-section of the vertical Hall element 100 along the cut B-B'. The vertical Hall element 100 is formed on a semiconductor substrate 101. The semiconductor substrate 101 might be a low doped silicon substrate having the first conductivity type. The first conductivity type is preferably p-type. The substrate has a first surface 101a and a second surface 101b. The two surfaces are opposing and parallel to each other. The second surface 101b is obtained by thinning of the substrate from the backside, i.e. from the side opposite to the first surface 101a. The vertical Hall element 100 is formed in a well 102 having the second conductivity type. The well 102 extends from the first surface 101a and is exposed at the second surface 101b. The well 102 forms the Hall plate or defines the Hall sensor region of the vertical Hall element 100. The vertical Hall element 100 has four terminals which are indicated by the numbers 1, 2, 3 and 4. The terminals 1 and 2 are arranged on the first silicon surface 101a, and the terminals 3 and 4 are arranged on the second silicon surface 101b. The terminals 1 and 2 are formed at the first surface 101a are in contact with the well 102. Likewise, the terminals 3 and 4 formed at the second surface 101b are in contact with the well 102. The two terminals 1 and 2 on the first surface have the same width and the same length. Likewise, the two terminals 3 and 4 on the second surface have the same width and the same length. The terminal 4 is located directly below terminal 1 in the sense that a virtual straight line between the center of terminal 1 and the center of terminal 4 is perpendicular to the silicon surface 101a. The terminal 3 is located directly below the terminal 2 in the same sense. For each of the two terminals arranged on the first surface 101a, a shallow and highly doped region 103 is formed extending from the first surface into the substrate. The highly doped regions 103 have the second conductivity type, which is the conductivity type of the well 102. The highly doped regions 103 might be silicided with some metal like cobalt. Metal contacts 105 are formed in the dielectric layer 104 connecting the highly doped regions 103 with metal lines of a first metal layer 106 embedded in the dielectric layer 104. The substrate 101 is bonded onto a carrier substrate 201 with the top surface 104a of the dielectric layer 104. The carrier substrate 201 can be silicon substrate as well. At the second surface 101b shallow and highly doped regions 303 are formed for each of the two terminals 3 and 4 extending from the second surface 101b into the substrate. The highly doped regions 303 have the second conductivity type, which is the conductivity type of the well 102. A dielectric layer 304 is disposed on the second surface 101b. The dielectric layer 304 is structured in such a way that contact holes are formed connecting the highly doped regions 303. A metal 305 is deposited into the hole contacts. Furthermore, the metal 305 is structured such that metal wires are formed on the second surface of the substrate. A passivation layer 308 is disposed on the dielectric layer 304 and the metal layer 305.

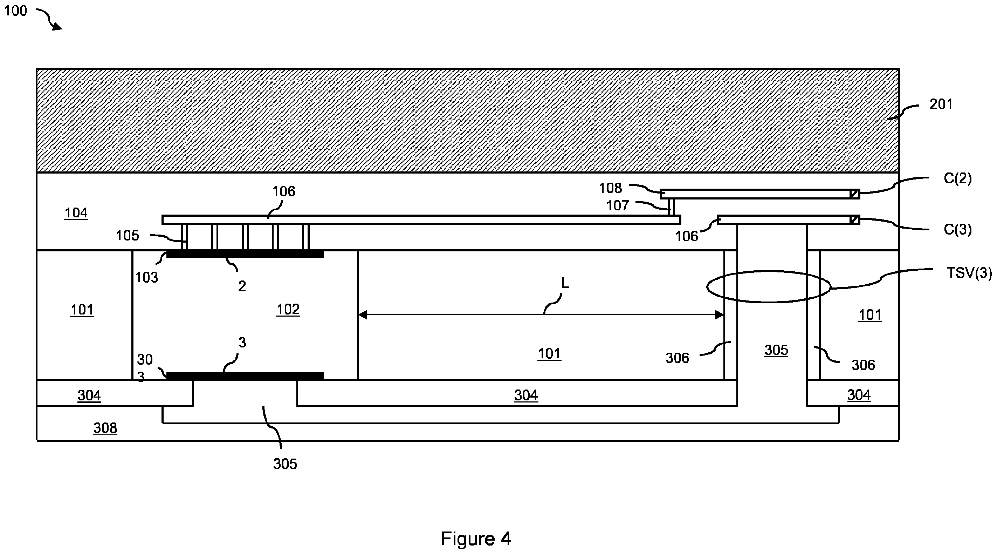

Fig. 4 is another representation the vertical Hall element 100 along the cut direction B-B'. To complement Fig. 3, a through silicon via (TSV) is depicted on the right side of Figure 4. The through silicon via provides a vertical conductive path through the substrate 101 connecting the terminal 3 disposed on the second surface 101b to the metal wiring formed on the first silicon surface. The through silicon via associated with the terminal 3 is denoted by TSV(3). For each terminal disposed on the second surface 101b there is one through silicon via connecting the terminal to the wiring formed on the first surface. As the vertical Hall element 100 has two terminals placed on the second surface, there are also two through silicon vias. The through silicon via TSV(3) is in contact with the portion 106 of the first metal layer embedded in the dielectric layer 104. At the second surface 101b, the through silicon via TSV(3) is connected to the terminal 3 by the metal wiring 305. In this way, the terminal 3 can be accessed at the point C(3). As shown in Fig. 4, the terminal 2 formed on the first surface 101a can be accessed electrically at point C(2). The through silicon via is filled with a conductive material 305 which could be the same material which is used for the metallization on the second surface. For example, this material could be Aluminium. However, other metallization schemes could be considered as well. In one scheme the metal disposed in the through silicon is copper or tungsten, while the metal used for the wiring and for the filling of the contact holes connecting the highly doped regions 303 is aluminium. In another scheme, the metal disposed in the through silicon via and the metal disposed in the contact holes connecting the highly doped regions 303 is tungsten, while the metal used for wiring on the second surface is aluminium. The conductive filling 305 of the through silicon via is isolated from the silicon substrate 101 by the dielectric liner 306 disposed onto the inner surfaces of the through silicon via. The through silicon via is placed at a distance L from the well 102 in which the Hall terminals are formed. A current I driven through the through silicon via gives rise to a magnetic field parallel to the silicon surface. The strength of the induced magnetic field at the location of the vertical Hall element is B = µ₀/(2πL)·I. To minimize this perturbing effect, the distance L can be set large enough. For instance, if the Hall current is lmA and the distance L is set to 100µm, the induced magnetic field strength is 2µT, which is well below the measurement resolution of available vertical Hall elements.

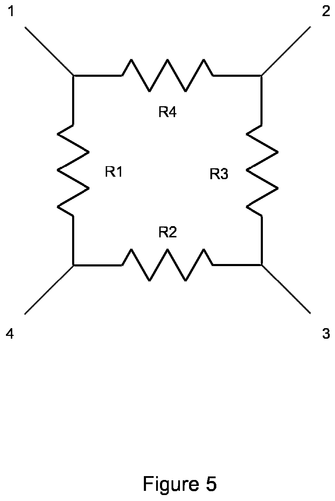

A Hall element having four terminals can be represented by an equivalent circuit as shown in Fig. 5. The four terminals 1, 2, 3 and 4 are connected via the four resistances R1, R2, R3 and R4 (Wheatstone bridge). If all four resistances are equal, the offset, i.e. the Hall voltage measured in the absence of a magnetic field, is zero. As is well known in the art, if one of the four resistances R1, R2, R3 and R4 is different while the other three resistances are all equal, the offset of the Hall element can be cancelled by application of the current spinning technique. In US 2016/0154066 A1 it is shown that the offset can be cancelled provided that the two resistances R1 and R3 or the two resistances R2 and R4 are equal.

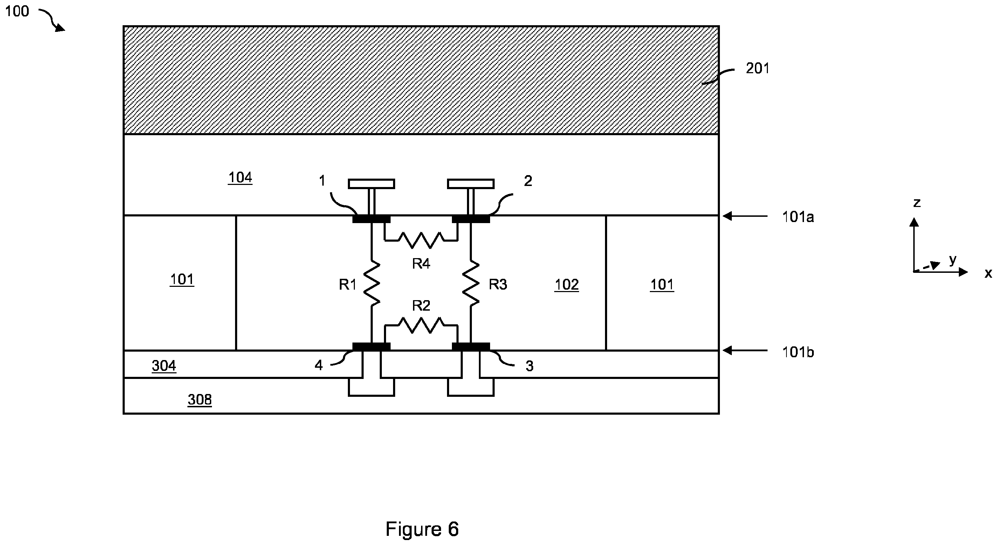

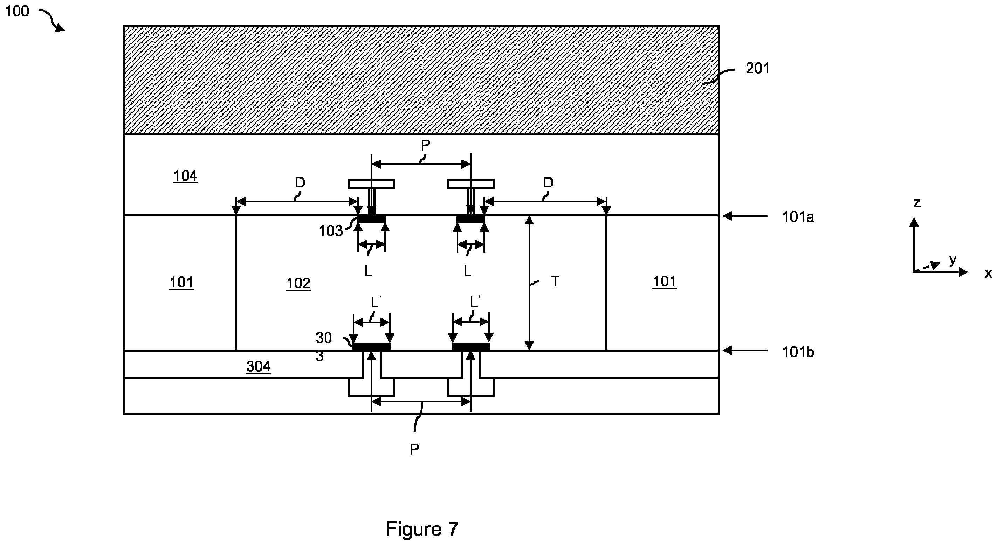

In Fig. 6 the four resistances R1, R2, R3 and R4 are indicated for the vertical Hall element 100. In Fig. 7 the geometric dimensions of the vertical Hall element 100 are delineated. L denotes the size of the terminals 1 and 2 in direction of the cut A-A'. L' denotes the size of the terminals 3 and 4 in direction of the cut A-A'. The sizes of the terminals are defined by the lateral dimensions of highly doped regions 103 and 303, respectively. T denotes the thickness of the silicon substrate after thinning. P denotes the distance between the center of terminal 1 and the center terminal 2 on the first surface 101a. Since the terminal 4 has the same but opposite location of terminal 1 and terminal 3 has the same but opposite location of terminal 2, the distance between the center of terminal 3 and center of terminal 4 on the second surface is also P. D denotes the distance between the edge of the terminal 1 and the boundary of the well 102 along cut direction A-A'. The distance between the edge of terminal 2 and the boundary of well 102 on the right side of Fig. 7 is D as well. The distance D can also be zero.

For the vertical Hall element 100 as shown Fig. 6 and 7, the resistances R2 and R4 are not necessarily equal. Possible causes for a difference between R2 and R4 are, for example, a doping gradient of the well 102, a difference in the contact resistances on the first and the second surface, or the additional series resistance associated with the through silicon vias. However, as a matter of fact, the size L' of the terminals 3 and 4 can be adjusted with respect to the size L of the terminals 1 and 2 such that the resistances R2 and R4 are approximately same.

Similarly, for the vertical Hall element 100 as shown Fig. 6 and 7, the resistances R1 and R4 are not necessarily equal. However, as a matter of fact, for given substrate thickness T and distance D to the boundary of the well 102, the distance P between terminal 1 and terminal 2 can be adjusted such that resistances R1 and R4 are approximately same.

For geometrical reasons the resistances R1 and R3 are equal provided that the distance D to the boundary of the well is same for the terminal 1 and the terminal 2. If due to misperfections of the manufacturing process the terminals 3 and 4 are misaligned in x-direction (along cut A- A') with respect to terminals 1 and 2, or if the well 102 is misaligned in x-direction with respect to the terminals 1 and 2, the equality of R1 and R3 does not hold anymore. However, if D is very large, R1 and R3 are approximately equal even if terminals 3 and 4 are misaligned in x-direction. Also, if D is very large, R1 and R3 are approximately equal even if the well 102 is misaligned with respect to the terminals 1 and 2.

After optimization of the design parameters P, T, D, L and L' the vertical Hall element can be represented by a Wheatstone bridge with the four resistances R1, R2, R3 and R4 having all nearly the same value. In other words, the vertical Hall element has a nearly four-fold symmetry.

In operation, the terminal 1 of the vertical Hall element 100 can be connected to a current source and the terminal 3 be connected to ground. In this way a current is forced in approximately diagonal direction through the Hall sensor region. A Hall voltage can be acquired between the terminals 2 and 4. The Hall voltage is representative for a magnetic field perpendicular to plane of the terminal 1, 2, 3 and 4. Also the terminal 2 can be connected to a current source and the terminal 4 be connected to ground. Then a Hall voltage can be acquired between the terminal 1 and 3. The Hall voltage is again representative for a magnetic field perpendicular to plane of the terminal 1 , 2, 3 and 4. Along the same line, the terminal 3 can be connected to a current source and terminal 1 be connected to ground. The Hall voltage acquired between the terminals 4 and 2 is again representative for a magnetic field perpendicular to plane of the terminal 1, 2, 3 and 4. Along the same line, the terminal 4 can be connected to a current source and terminal 2 be connected to ground. The Hall voltage acquired between the terminals 1 and 3 is again representative for a magnetic field perpendicular to plane of the terminal 1, 2, 3 and 4. These are the four phases of the spinning current method considered for the vertical Hall element 100.

Owing to the nearly four-fold symmetry of the vertical Hall element the offset for each single phase of operation is already low. As a result, by averaging over all four phases, a very small value for the residual offset can be obtained. As is known by skilled persons, the current spinning technique can be combined with orthogonal coupling of two or four Hall elements to further reduce the residual offset.

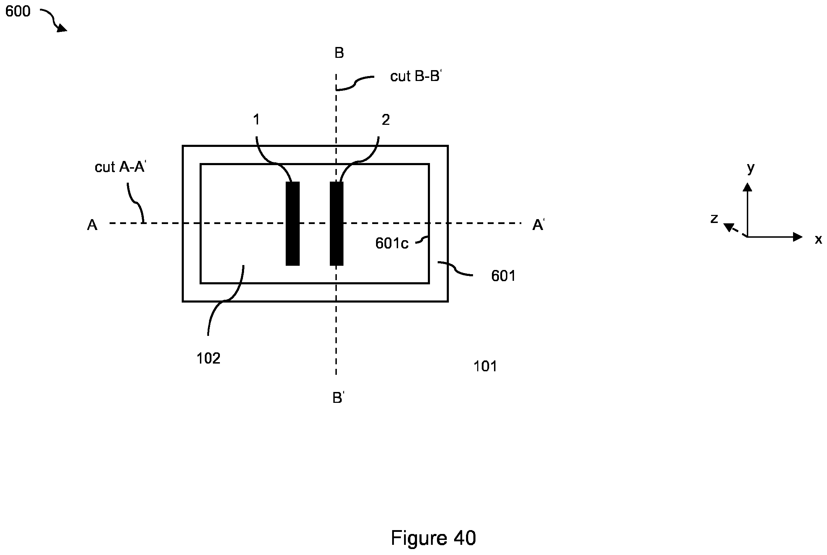

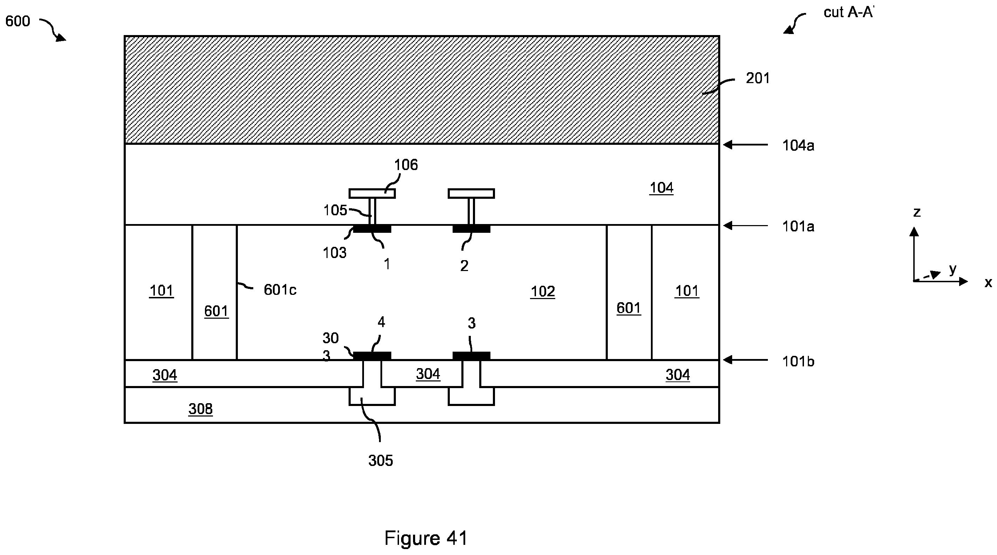

Fig. 40 and 41 show the vertical Hall element 600, which represents another embodiment of the invention. In Fig. 40 the vertical Hall element 600 is depicted from above, looking on the first silicon surface. Fig. 41 shows the vertical Hall element 600 along the cut direction A-A' indicated in Fig. 40. Like the vertical Hall element 100, the vertical Hall element 600 is formed on the semiconductor substrate 101, which might be a low doped silicon substrate having the first conductivity type. The Hall terminals 1 and 2 formed on the first surface 101a are in contact with the well 102, which extends from the first surface 101a into the substrate and which is exposed at the second surface 101b. The two Hall terminals 3 and 4 formed on the second surface are in contact with the well 102. The well 102 has preferably n-type conductivity, which can be the first or the second type of conductivity. The highly doped regions 103 and 303 have the same conductivity type as the well 102, i.e. n-type. As shown in Fig. 40, the Hall terminals 1 and 2 disposed in the well 102 are entirely enclosed by the deep trench isolation structure 601. The well 102 extends in x- and y- direction to the inner surfaces 601c of the deep trench isolation 601 so that inside of the deep trench enclosure there is no boundary between the well 102 and substrate 101. Referring to Fig. 41, the deep trench isolation structure extends from first surface 101a to the second surface 101b. The inner surface 601c of the deep trench isolation enclosure is everywhere in contact with the well 102. The deep trench isolation consists of a dielectric material.

As in the first embodiment, the design of the vertical Hall element 600 can be optimized such that a nearly four- fold symmetry is achieved. As result, also the offset of vertical Hall element 600 can be effectively reduced. Moreover, since the Hall sensor region 102 of the vertical Hall element 600 is bounded by a dielectric isolation enclosure, no depletion zones can be formed during the operation of the vertical Hall element 600 along the boundaries of the well 102.

Consequently, the vertical Hall element of the second embodiment is characterized in addition by a high degree of linearity.

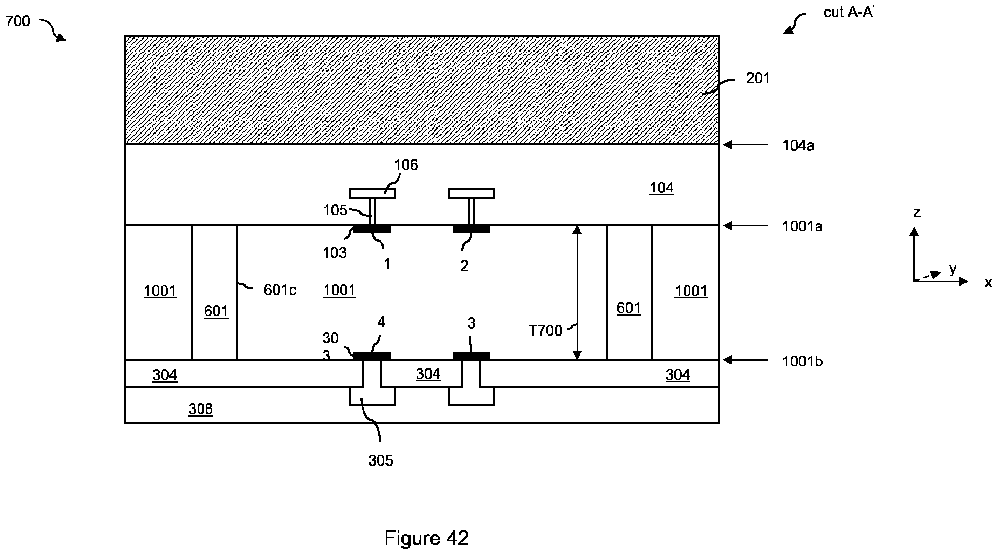

Another embodiment of the invention is presented in conjunction with Fig 42. The vertical Hall element 700 is formed on a semiconductor substrate 1001 having the first conductivity type, which is either p-type or n-type. The terminals 1 and 2 are disposed on the first surface 100la with the highly doped regions 103 having the first conductivity type, i.e. the same conductivity type as the substrate 1001. The terminals 3 and 4 are disposed on the second surface l00lb obtained by thinning of the primary substrate from the second side. The highly doped regions 303 have the first conductivity type as well. T700 denotes the thickness of the substrate 1001. The thickness T700 of substrate 1001 might be in the range of 5 micrometers to 100 micrometers, and more preferably in the range of 10 micrometers to 50 micrometers. The terminals 1 and 2 on the first surface and the terminals 3 and 4 on the second surface are enclosed in x- and y-direction by the deep trench isolation structure 601. The deep trench isolation structure 601 extends from the first surface 1001a to the second surface 1001b. The deep trench isolation consists of a dielectric material.

In the embodiment of the vertical Hall element 700, the Hall sensor region is made up by that portion of the semiconductor substrate 1001 that is enclosed and confined by the deep trench isolation structure 601. Like in the first and second embodiment, the design of the vertical Hall element 700 can be optimized so that a nearly four-fold symmetry is achieved with respect to the four terminals. Since the Hall sensor region is bounded by the dielectric material of the deep trench isolation structure 601, no depletion zones can develop during operation of the vertical Hall element 700, ensuring a high degree of linearity. The sensitivity of the vertical Hall element 700 depends among others on the conductivity type of substrate 1001, the doping level of substrate 1001 and the thickness T700. The inventors appreciate that using a semiconductor substrate with n-type conductivity and optimum doping concentration, a relatively high sensitivity can be obtained for the vertical Hall element 700 provided that the thickness T700 is in a preferred range of 10 micrometers to 50 micrometers.

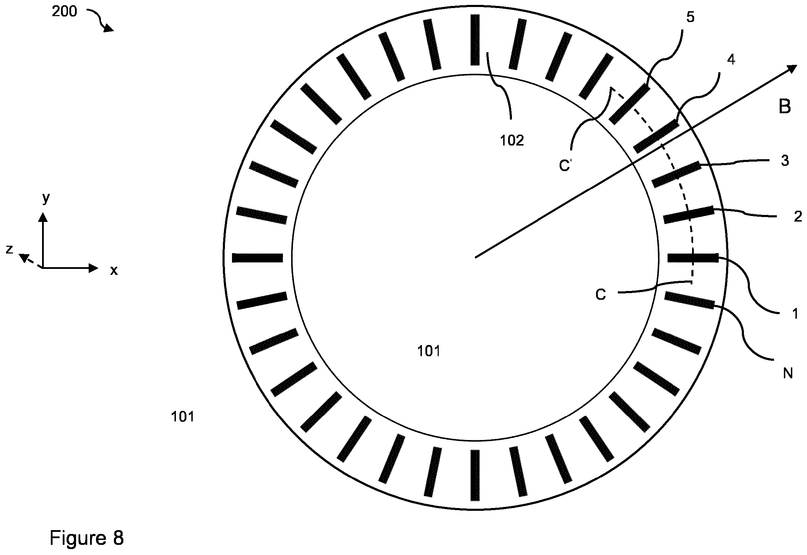

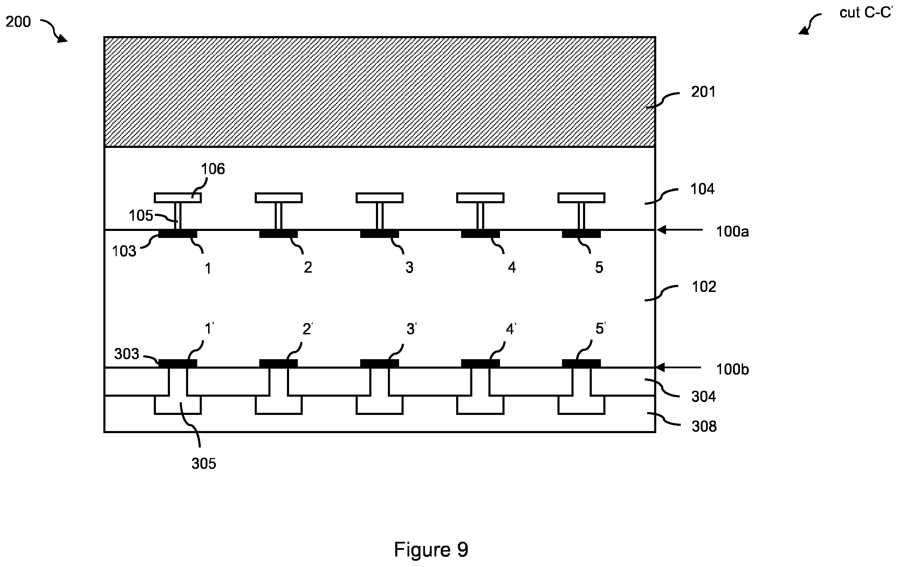

Fig. 8 and 9 show a circular vertical Hall element according to another embodiment of the invention. In Fig. 8 the vertical Hall element 200 is depicted from above, looking onto the first surface 101a of the semiconductor substrate 101. Fig. 9 provides a circular cut of the vertical Hall element 200 along the indicated path between C and C'. The circular vertical Hall element 200 has N terminals disposed on the first surface 101a and N terminals disposed on the second surface 101b of the thinned semiconductor substrate 101. The N terminals on the first surface are arranged on a circle and are formed in the ring-shaped well 102. The ring-shaped well 102 constitutes the Hall plate or Hall sensor region of the circular vertical Hall element 200. The ring-shaped well 102 extends from the first surface 101a and is exposed at the second surface 101b obtained by thinning of the semiconductor substrate 100 from the second side. The N terminals on the first silicon surface have equal size and are equally spaced. The N terminals disposed on the second surface are also arranged on a circle such that the two circles are concentric and have the same radius. The N terminals disposed on the second silicon surface have also equal size, are equally spaced and in are contact with the ring-shaped well 102 being exposed on the second surface. Moreover, the arrangement is such that for each terminal k on the first surface 101a, there is one terminal k' on the second surface 101b, which is located directly below the terminal k, i.e. a virtual straight line connecting the center of terminal k with the center of terminal k' is perpendicular to the silicon surface 101a. Moreover, N = 2M, where M is an integer > 2. In Fig. 8 also a possible direction of the magnetic field B is indicated.

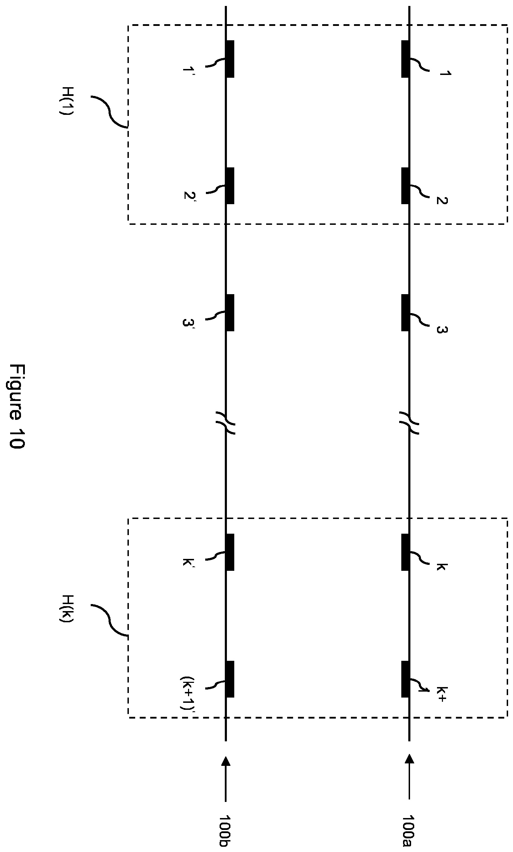

Fig. 10 is a simplified representation of the terminals on the first surface 101a and the second surface 101b along a circular cut as indicated in Fig. 8. A first vertical Hall sub-element is formed by the four terminals 1, 2, 2' and 1'. This vertical Hall sub-element is denoted by H(1). By going one step to the right, a second vertical Hall sub-element can be formed by the four terminals 2, 3, 3' and 2'. This vertical Hall sub-element can be denoted by H(2). A k-th vertical Hall sub-element is formed by the four terminals k, k+1, (k+1)' and k'. It is denoted by H(k). With N terminals on the first surface and N terminals on the second surface, N such vertical Hall sub-elements can be formed. However, also less than N vertical Hall sub-elements can be formed in this way by increasing the step size. As the N vertical Hall sub-elements in general will not be measured at the same instant of time, they are called temporary vertical Hall elements. During the operation of the k-th vertical Hall sub-element, all terminals that do not belong the k-th vertical Hall sub-element are left open.

In a similar way as for the vertical Hall element 100, design parameters of the circular vertical Hall element 200 (not indicated in Fig. 9) can be optimized such that each temporary Hall element H(k) has a nearly four-fold symmetry is accomplished. As a result, very low residual offsets can be achieved for each temporary Hall element.

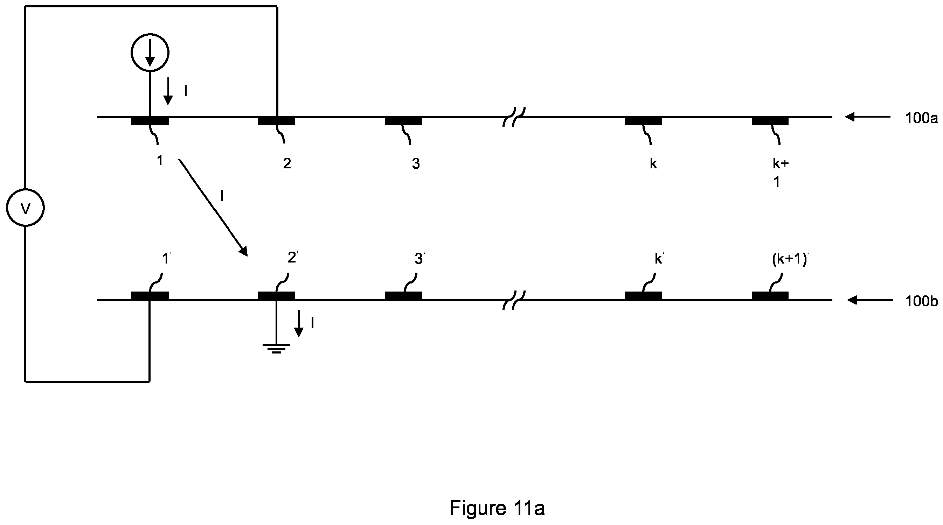

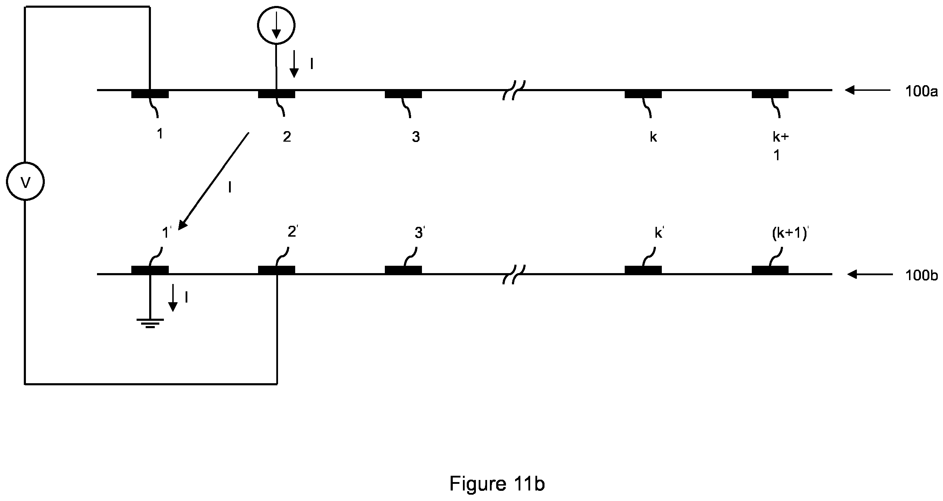

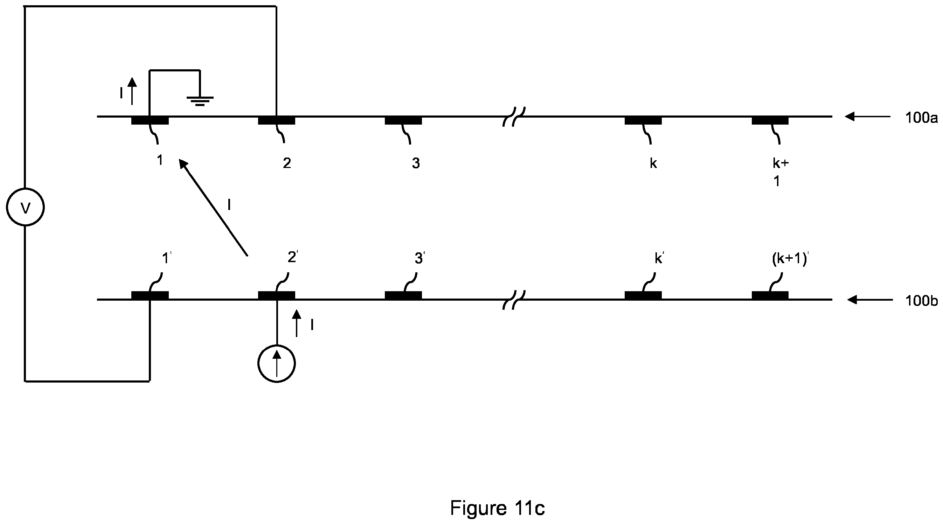

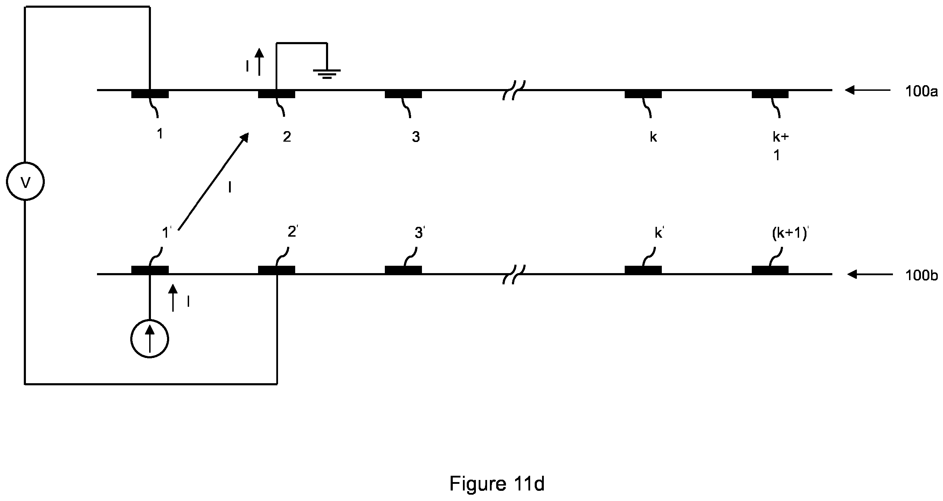

The Fig. 11a, 11b, 11c and 11d show the application of the spinning current method to the first temporary vertical Hall element H(l). In Fig. 11a the terminal 1 is connected to a current source and the terminal 2' is connected to ground. A Hall voltage is acquired between the terminals 2 and 1'. All other terminals are unconnected. The current direction through the well 102 is indicated by an arrow. This is the first phase of the current spinning. In the second phase, shown in Fig. 11b, the terminal 2 is connected to the current source and the terminal 1' is connected to ground. The Hall voltage is acquired between the terminal 2' and 1. All other terminals are unconnected. The current direction is indicated again and is rotated with respect to the first phase. In Fig 11c and Fig. 11d the third and the fourth phase is presented, respectively. By averaging over the acquired voltages of all four phases, a settled Hall voltage of the first temporary vertical Hall element H(1) is obtained. In the same way the spinning current method is applied to next temporary vertical Hall element H(2). In the same way spinning current method is applied to the temporary vertical Hall element H(k).

The direction of the magnetic field in the x-y-plane can be evaluated by measuring the N temporary Hall elements H(k), k=1...N one after the other. Also measuring a suitable subset of the N temporary Hall elements might be enough to determine the direction of the magnetic field. Also, measurement schemes could be conceived in which two or more temporary Hall elements are measured at the same instant of time provided the interaction is low. In any case, the accuracy with which the direction of the magnetic field in the x-y plane can be determined is enhanced by the offset reduction for each temporary Hall element.

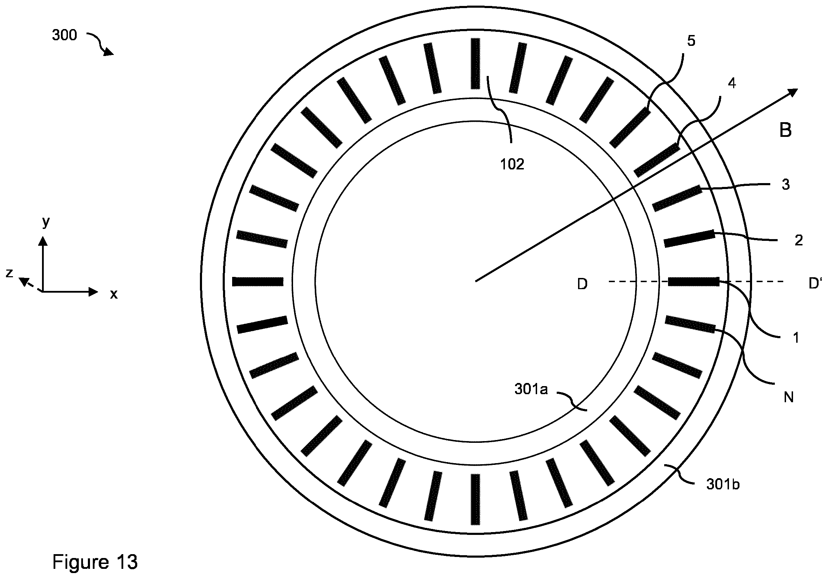

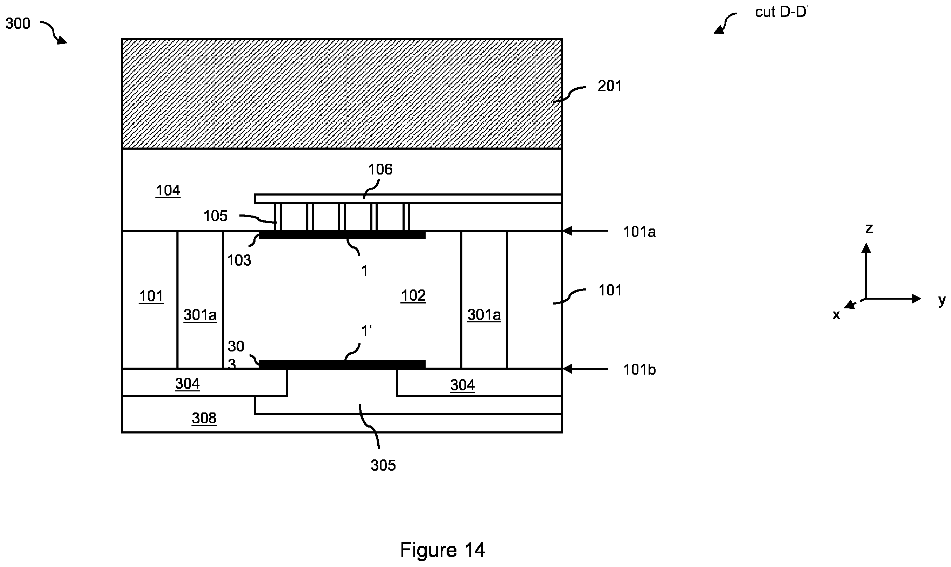

Fig. 13 and 14 show an alternative embodiment of the invention. In Fig. 13 the circular vertical Hall element 300 is shown from above, looking on the first surface 101a. In figure 14 the circular vertical Hall element 300 is shown along the indicated cut in x-direction from D to D'. The circular vertical Hall element 300 differs from the circular vertical Hall element 200 only in that there are in addition two ring-shaped isolation structures 301a and 301b. As can be seen from figure 14, the isolation structures 301a and 301b extend from the first surface 101a to the second surface 101b of the thinned silicon substrate. The two ring-shaped isolation structures 301a and 301b are concentric with the ring-shaped well 102. The area laterally enclosed by the two ring-shaped isolation structures is the well 102. In this way the isolation structures 301a and 301b laterally isolate the well 102 from the substrate 101. There is no p-n junction between the well 102 and the substrate 101 anymore. The isolation structures 301a and 301b are made of a dielectric material. The isolation structures can be realized by etching two ring-shaped trenches from the second surface 101b to the first surface 101a of the substrate and by filling the trenches with dielectric material such as silicon oxide.

As is known by someone skilled in the art, if a voltage is applied between two terminals in an n-type Hall plate, depletion zones form along the p-n junctions that bounds the Hall plate. As the depletion zones decrease the effective size of the Hall plate, the resistance of the Hall plate is increased. This effect introduces a non-linearity, which impedes the offset cancellation. This is known by those skilled in the art. In the embodiment 300 of the circular vertical Hall element, the Hall sensor region 102 is not bounded by p-n junctions. The dielectric isolation of the Hall sensor region 102 improves therefore the offset reduction further.

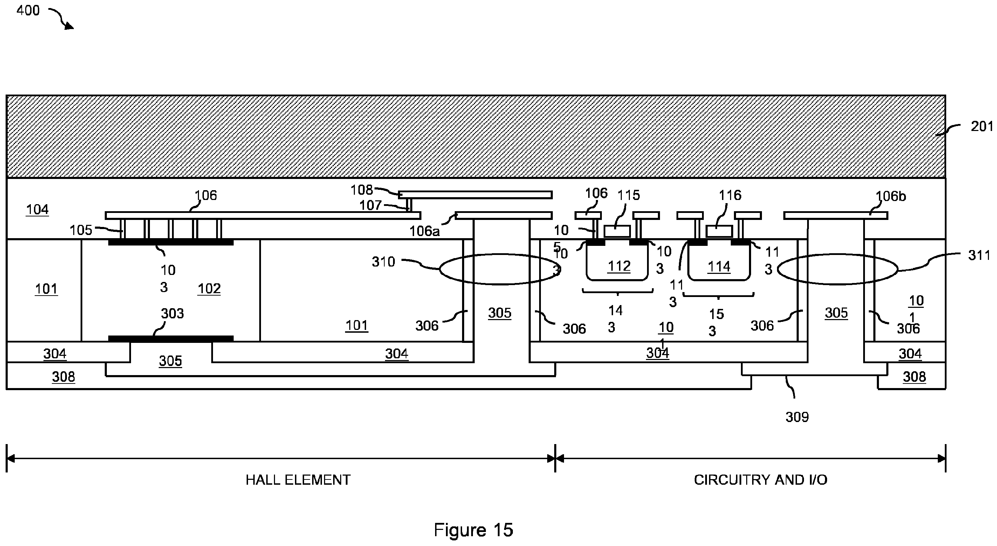

Fig. 15 shows a semiconductor device 400 having one or more vertical Hall elements. The semiconductor device 400 could be Hall IC, for instance a Hall IC for angular position measurement. On the left side of Fig. 15 the vertical Hall element with through silicon via 310 is shown. This part of the figure is identical to the Fig. 4. On the right side of the Fig. 15 two transistors 143 and 153 are depicted which should represent the circuitry needed to operate the vertical Hall elements. If the substrate is p-type, the transistor 143 is an NMOS and transistor 153 is a PMOS. On the very right of the Fig. 15 a second through silicon via, denoted by 311, is shown. The through silicon via 311 is part of the I/O of the semiconductor device 400. 309 denotes a bonding pad. The bonding pad 309 is formed with the metal layer 305. The through silicon via 311 achieves a connection between the wiring formed on the first surface of the substrate and the bonding pad 309, which is formed on the second surface of the thinned substrate 101. 106b denotes the landing pad of the through silicon via 311. The landing pad 106b is connected to the wiring disposed in the dielectric layer 104, which is not shown. In Fig. 15 two metal layers are shown on the first surface, however, there could be more than two metal layers as well.

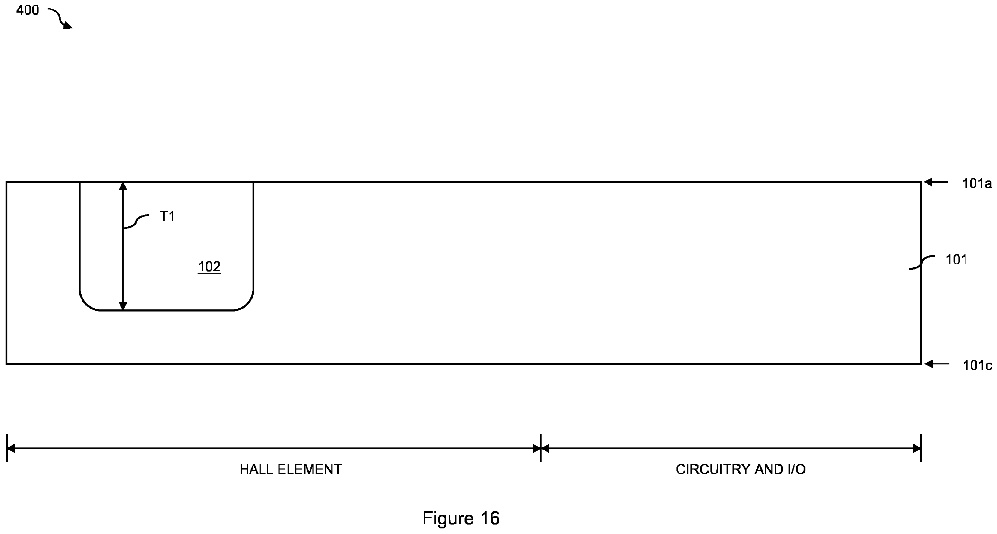

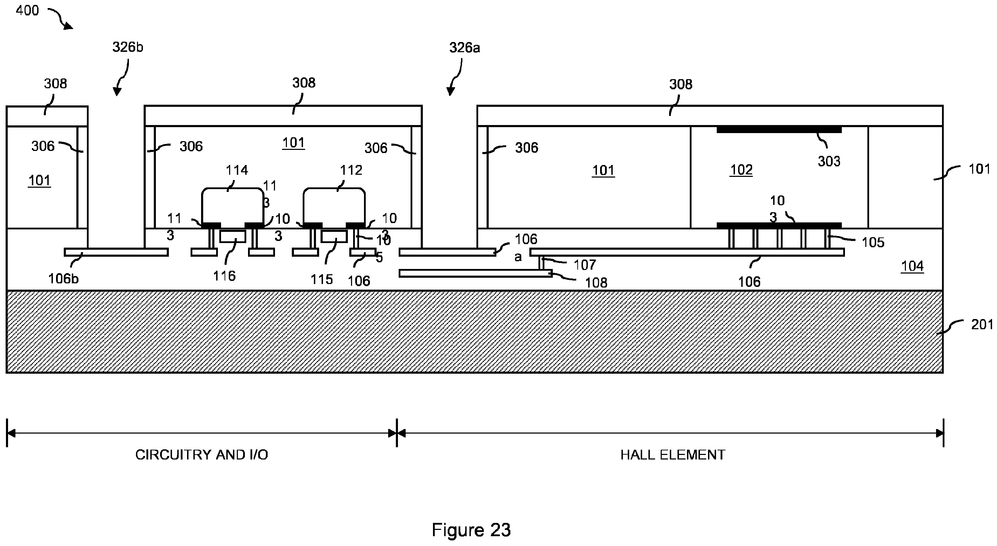

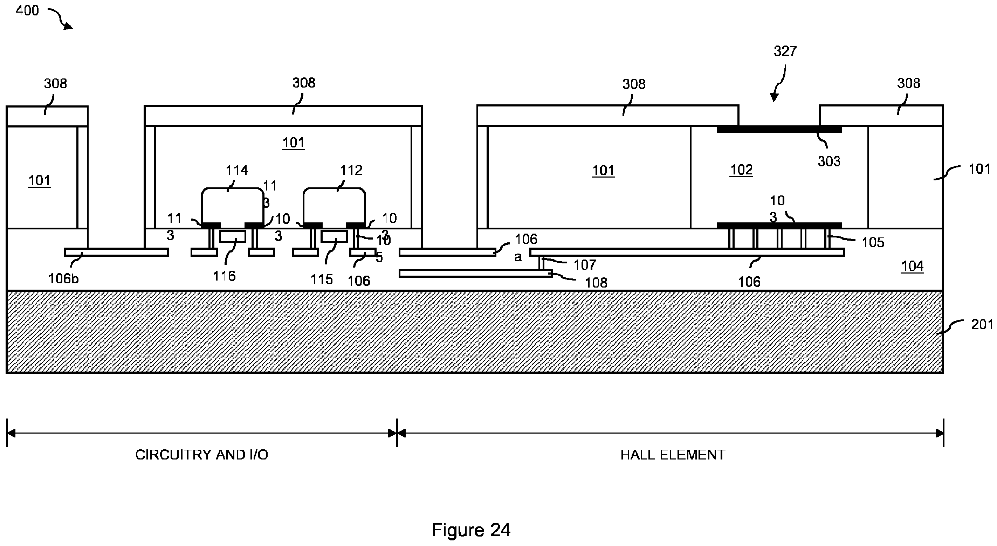

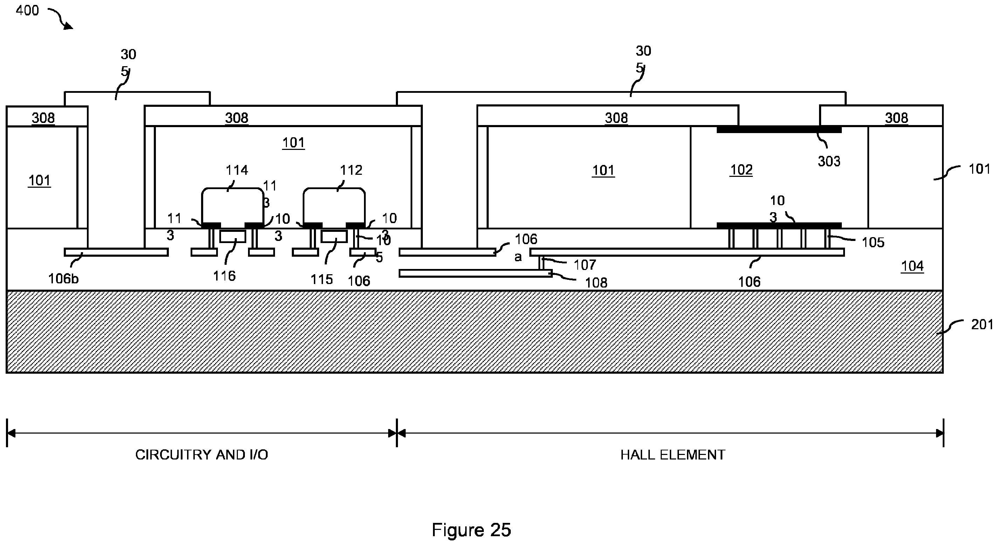

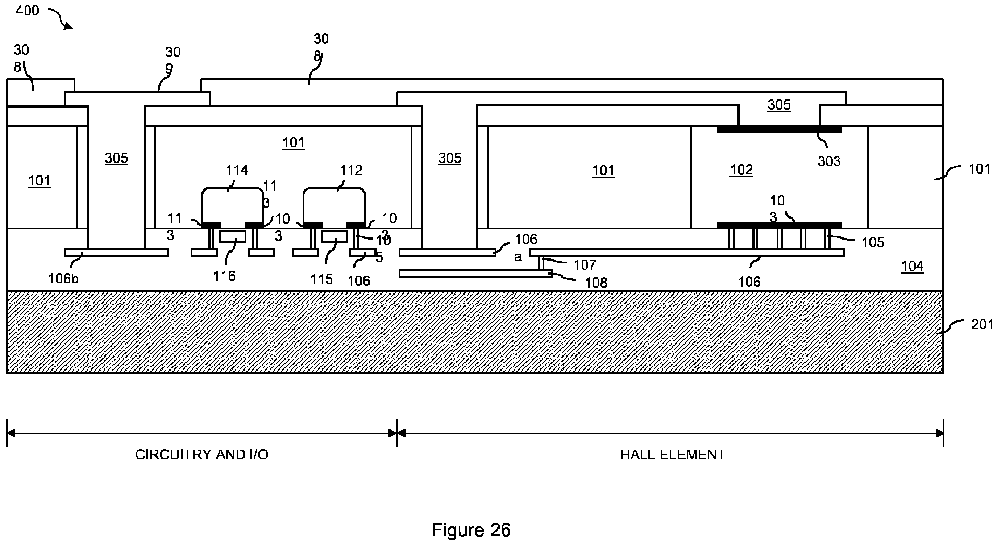

Fig. 16 to 26 show the manufacturing steps for the fabrication of the semiconductor device 400.

The basic manufacturing steps are explained in EP 2913847 A1.

In the following, only the significant differences are highlighted.

As shown in Fig. 16 a well 102 is formed in the substrate 101 having first conductivity type. The well 102 has the second conductivity type. The well 102 might be formed by sequence of masked implant steps with varied implant energy. The sequence of implant steps may include high energy implants having energies in the MeV range. After mask removal a furnace anneal is applied at a temperature between 1000°C and 1200°C for several hours. Implantation and furnace anneal conditions are optimized towards achieving a uniform dopant concentration in vertical direction. In Fig 16, Tl denotes the depth of the well 102 after furnace annealing. The depth Tl is greater than 4µm, and preferable greater than 6µm.

In the sequence of the following figures, the formation of an isolation structure like shallow trench isolation (STI) is not shown. However, it is assumed that shallow trench isolation is applied, and even it might present in the region of the vertical Hall element.

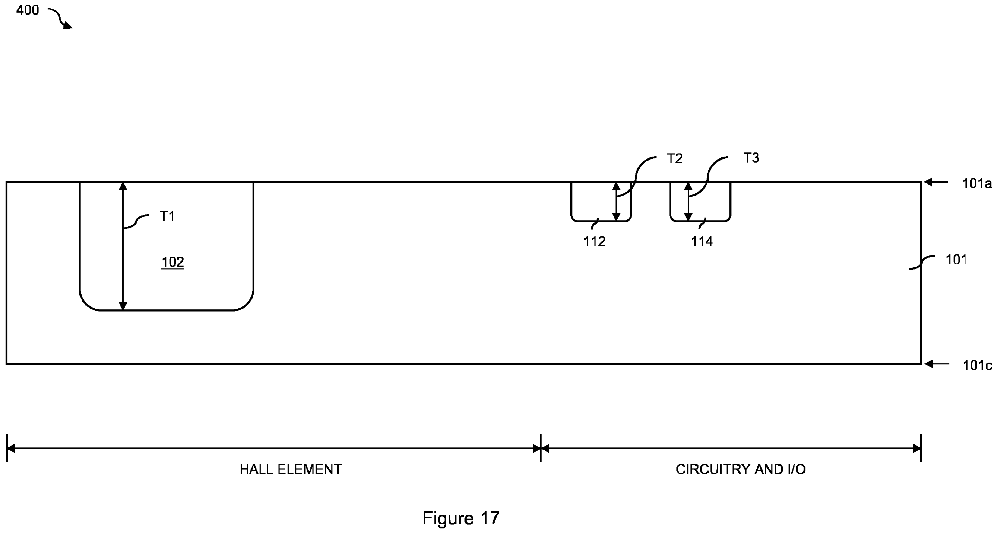

As shown in Fig. 17, transistor wells 112 and 113 are formed. 112 denotes a p-type well in which an NMOS transistor is formed and 113 denotes an n-type well in which a PMOS transistors is formed. The respective depths T2 and T3 of the wells 112 and 113 are lower than the depth Tl of the well 102.

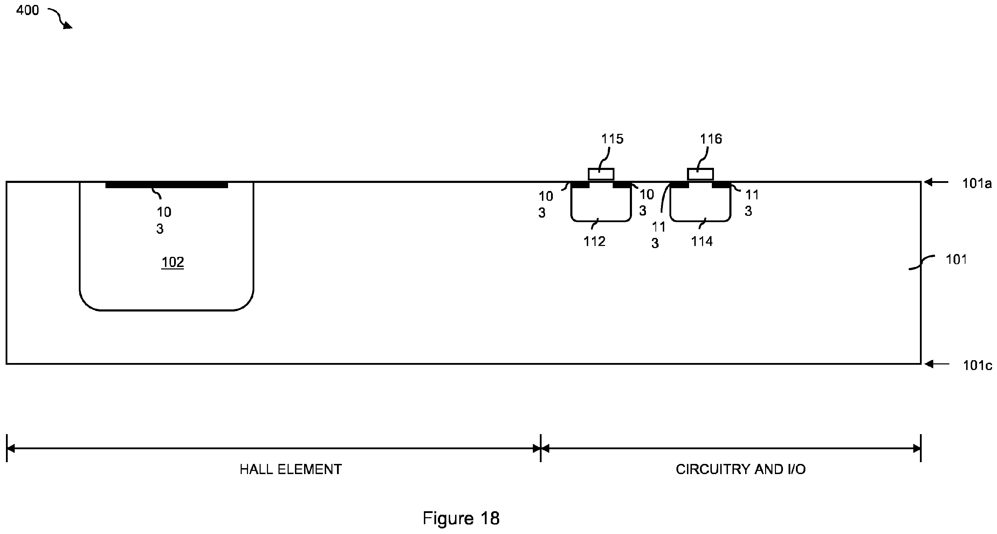

Turning to Fig. 18, transistor gates 115 and 116 for the PMOS and NMOS are formed, as well as the highly doped regions 103 and 113. 103 denotes a shallow and highly doped regions of second conductivity type and 113 denotes shallow and highly doped regions of first conductivity type. While the highly doped regions 103 and 113 constitute the source and drain regions of NMOS and PMOS transistors respectively, 103 is also used to form the highly doped regions of the Hall terminals on the first surface 101a. Alternatively, a dedicated mask and processing step could be used for the definition of doping regions 103 in the Hall sensor region 102.

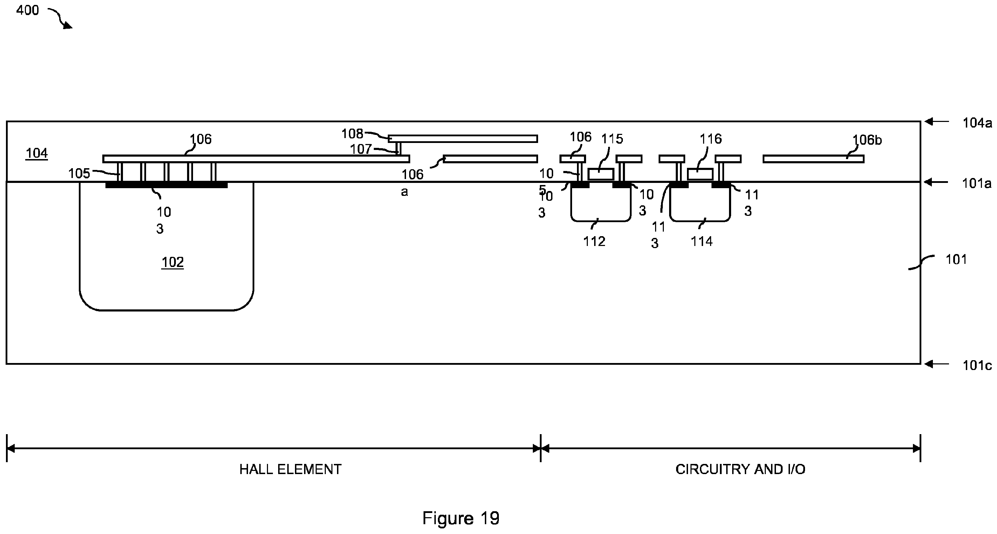

In Fig. 19, interconnection levels are formed using standard CMOS metallization schemes known in the industry. Metal portions 106a and 106b are embedded in the dielectric stack 104 to be used as landing pads for the formation of the through silicon vias. The top surface 104a of the dielectric stack 104 is planarized by chemical-mechanical polishing.

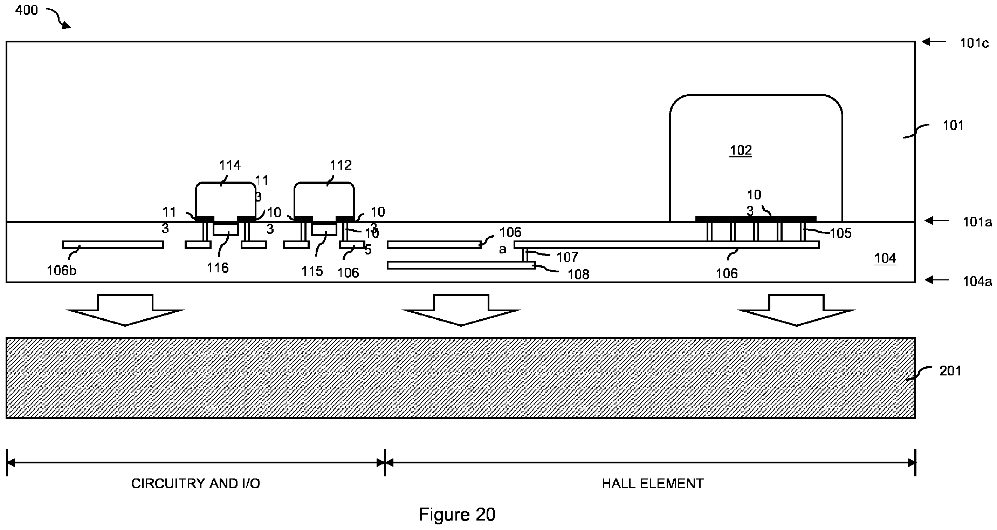

In Fig. 20, a carrier wafer 201 is provided. The carrier wafer 201 could be an inexpensive silicon substrate. The substrate 101 is flipped.

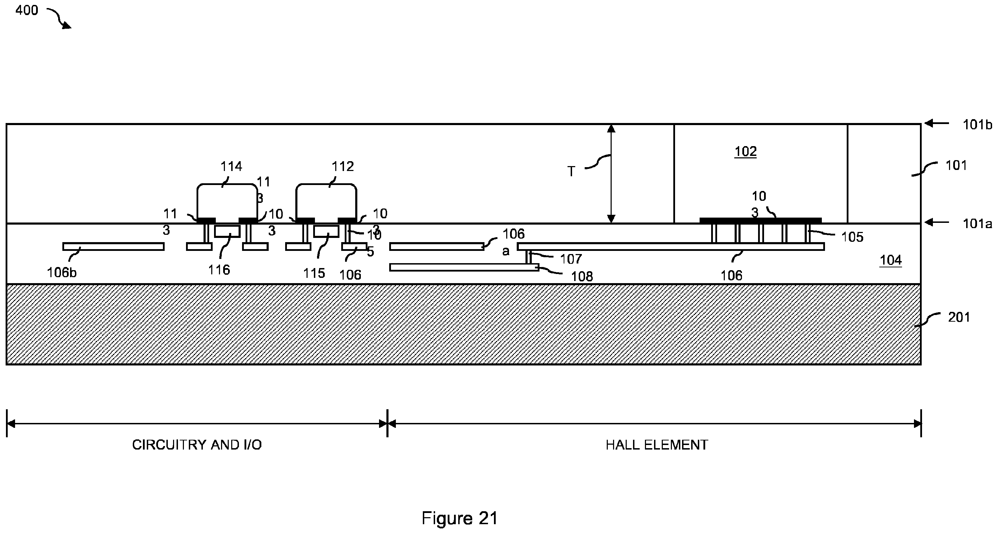

Turning to Fig. 21 the substrate 101 is bonded onto the carrier substrate 201 and after that the substrate 101 is thinned from the second side. 101c denotes the initial second surface of the substrate before the thinning process, 101b denotes the second surface of the substrate after thinning. T denotes the thickness of the silicon substrate after thinning. T is smaller than the depth T1 of well 102. In this way, the well 102 is exposed at the second surface after thinning.

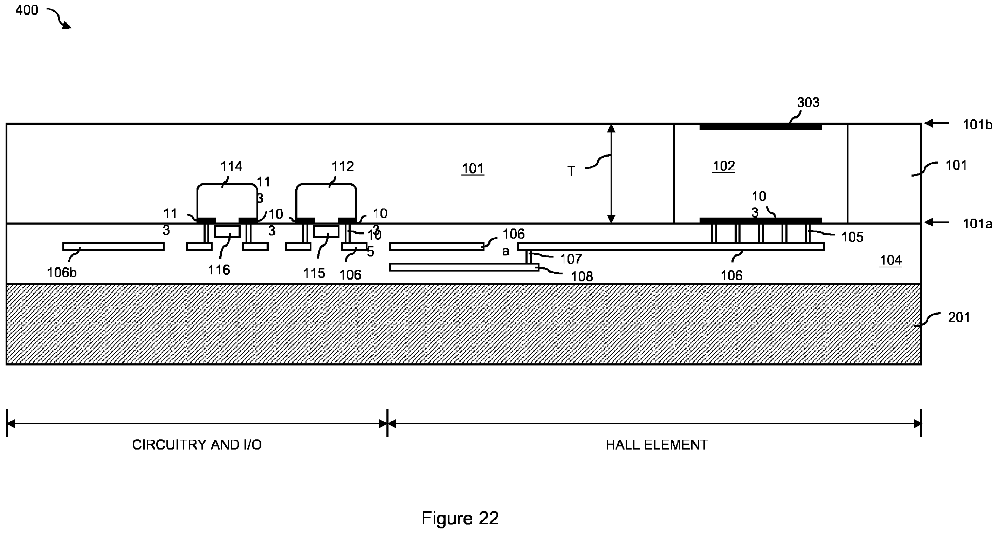

Turning to Fig. 22, a highly doped region 303 is formed on the second surface 101b within the well 102. The highly doped region 303 has the second conductivity type and is formed by masked shallow and high dose implantation followed by laser thermal annealing.

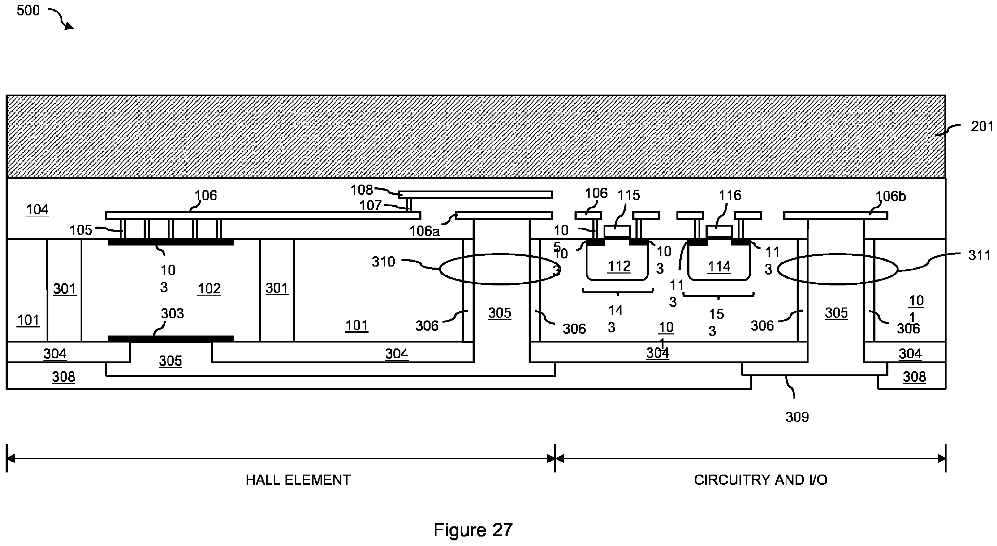

Fig. 27 shows a semiconductor device 500 having one or more vertical Hall elements 300. The semiconductor device 500 could be Hall IC, for instance a Hall IC for angular position measurement. In contrast to semiconductor device 400, semiconductor device 500 comprises one or more vertical Hall elements 300 having the Hall sensor region 102 confined by isolation structures 301.

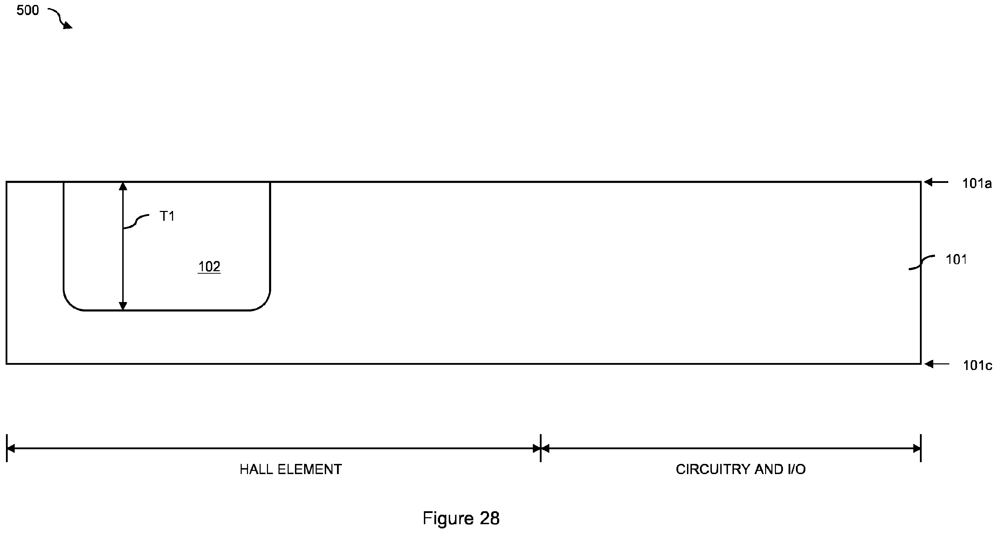

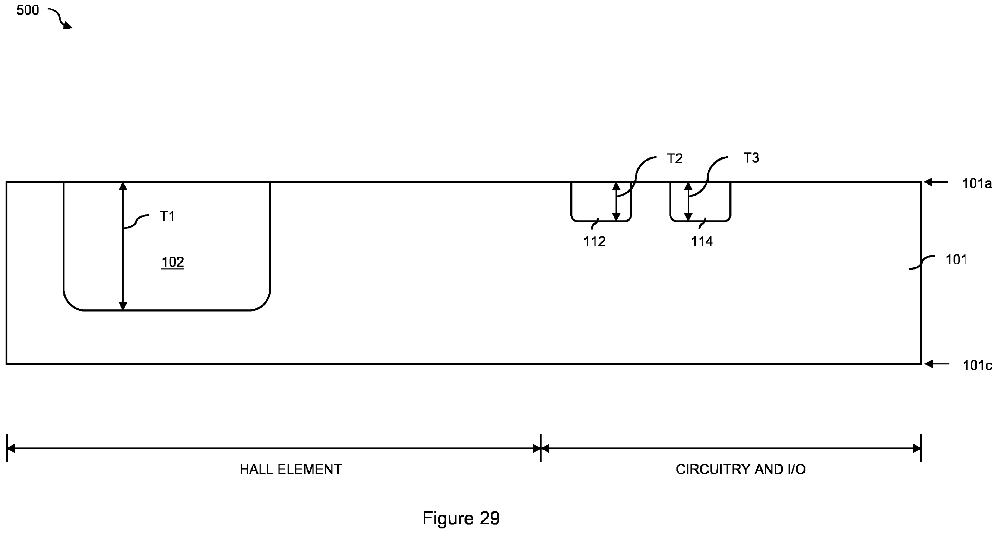

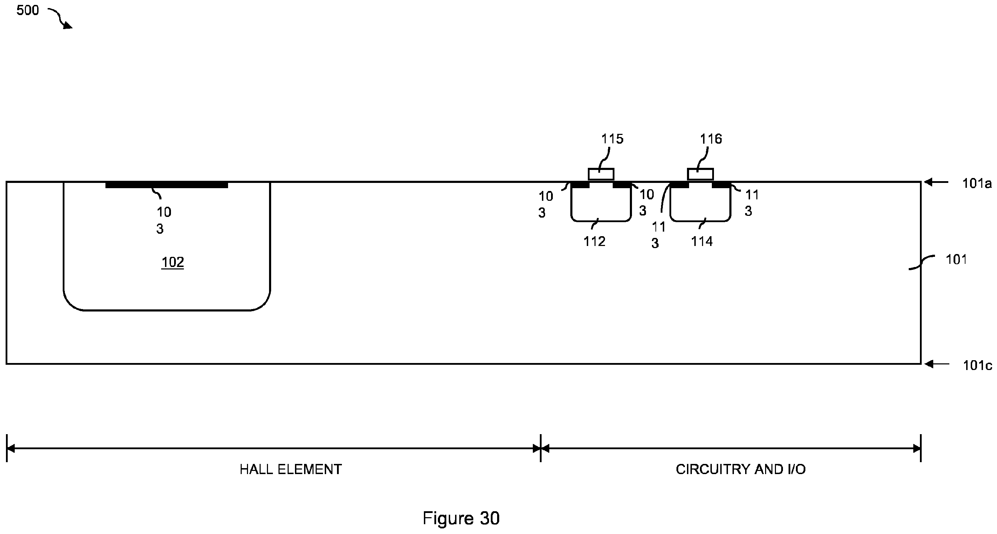

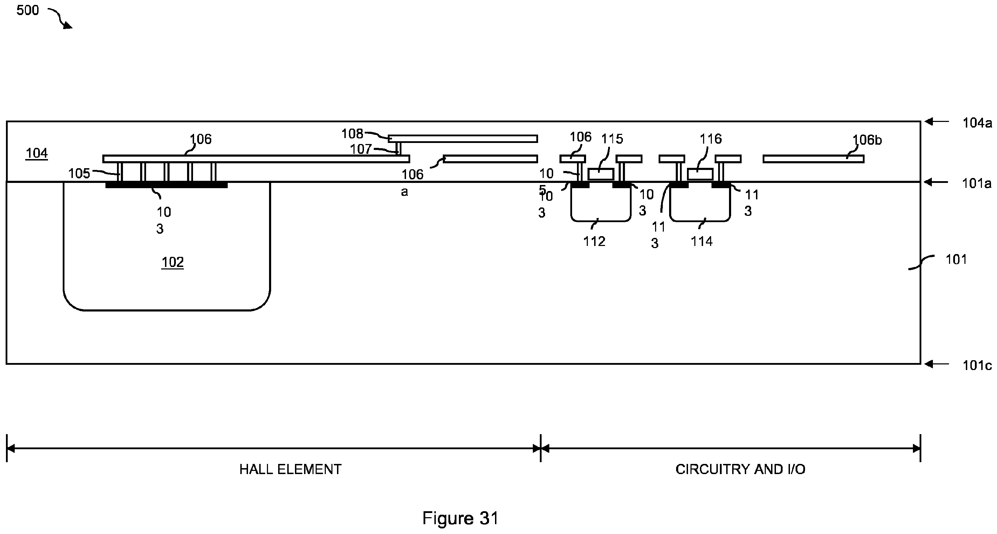

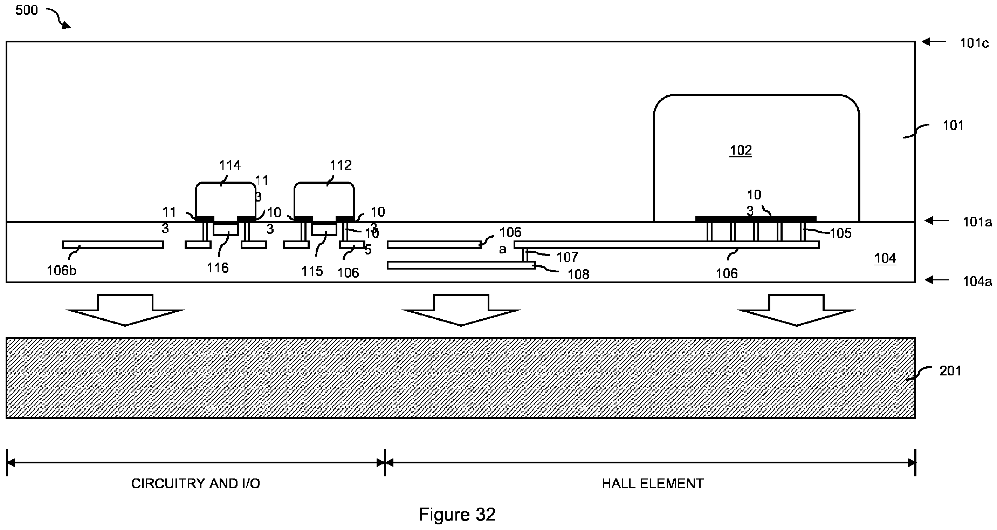

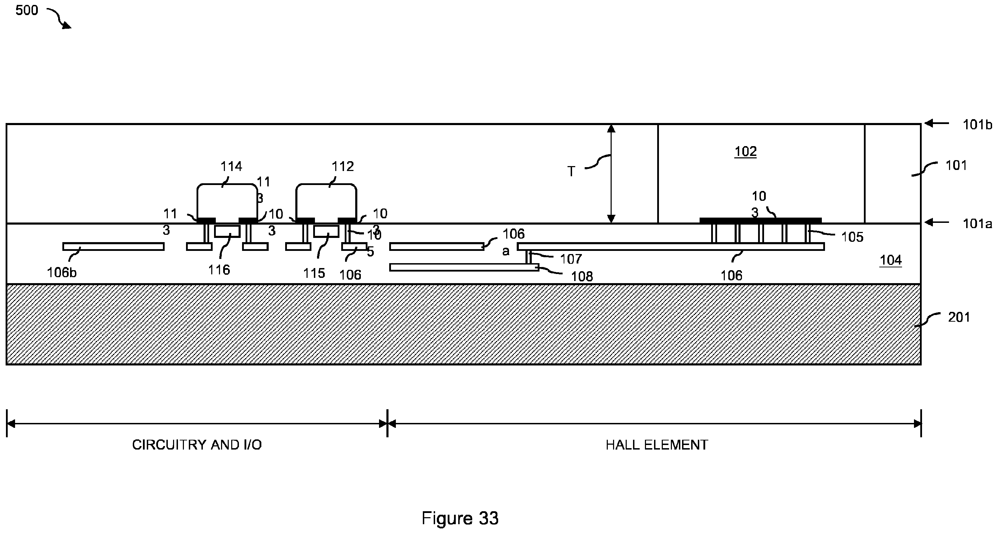

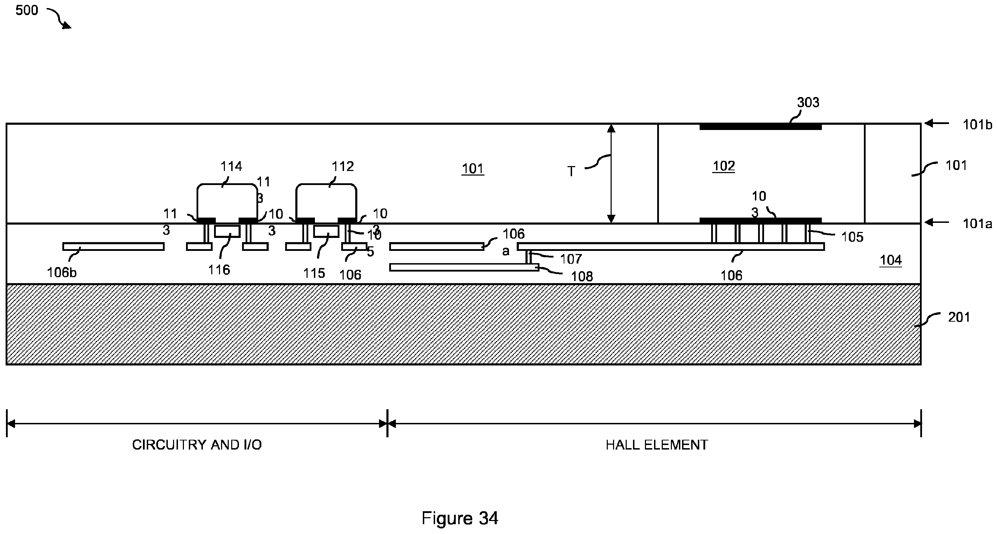

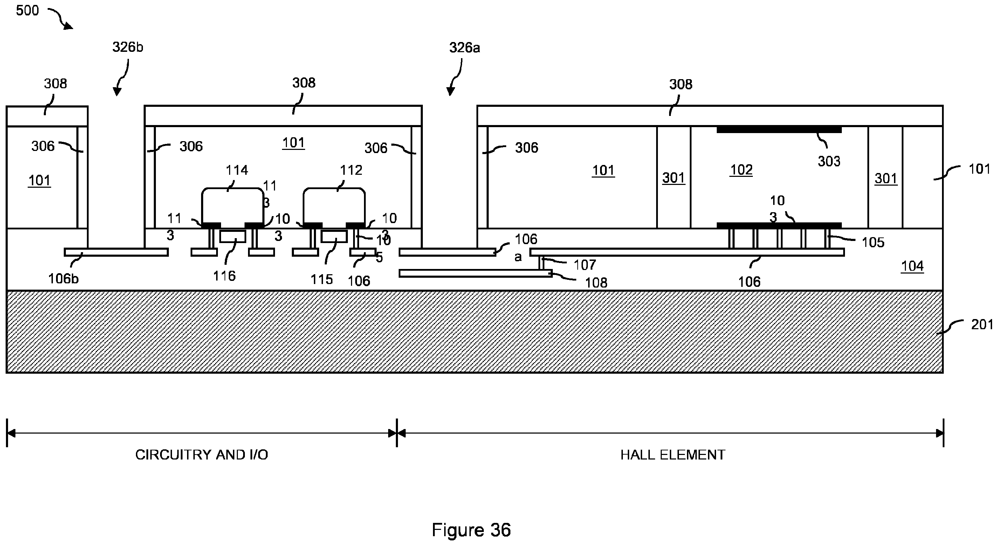

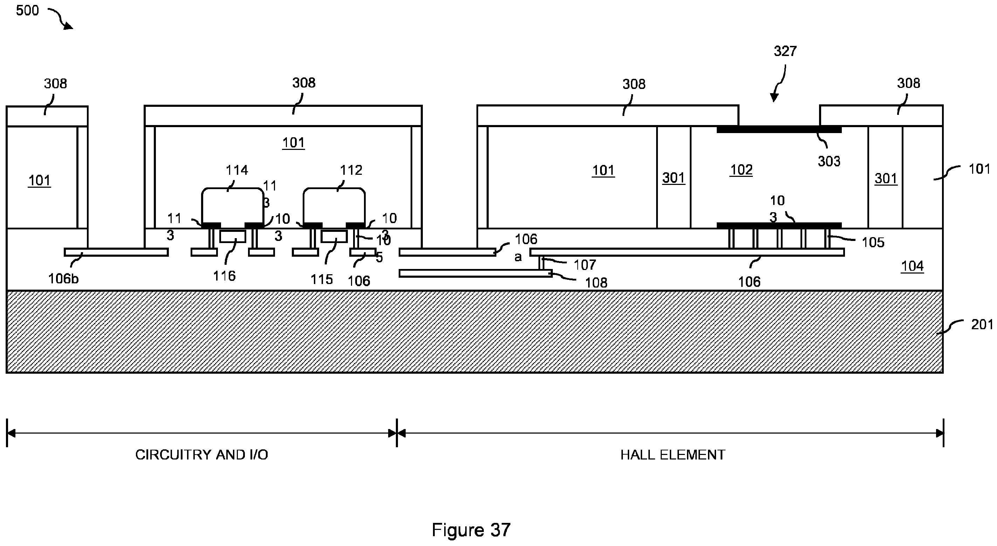

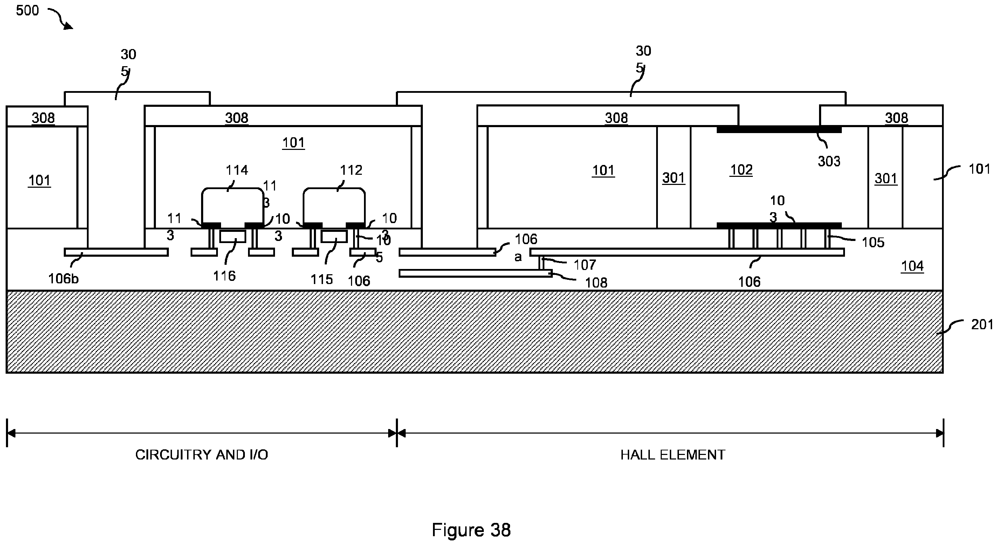

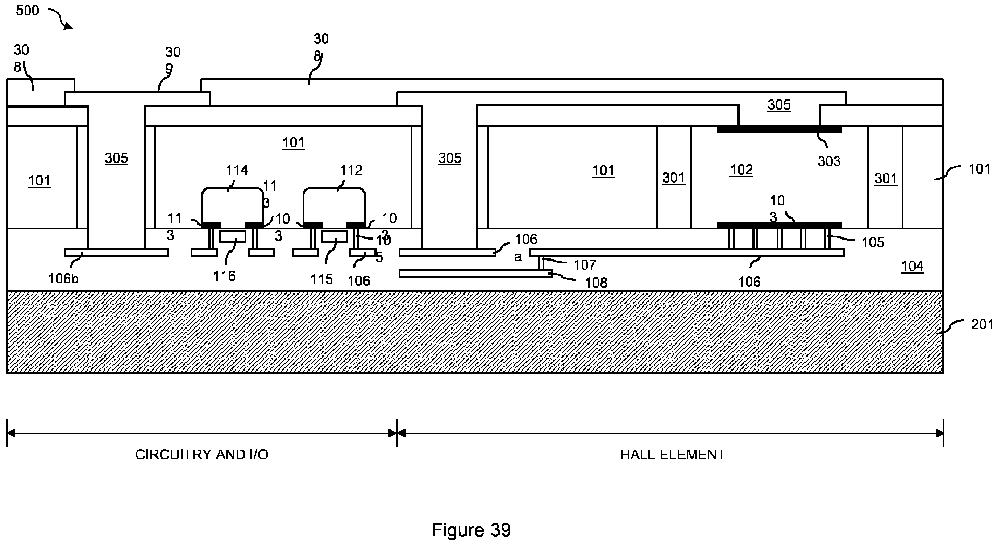

Fig. 28 to 39 show the manufacturing steps for the fabrication of the semiconductor device 500.

The basic manufacturing steps are explained in EP 2913847 A1.

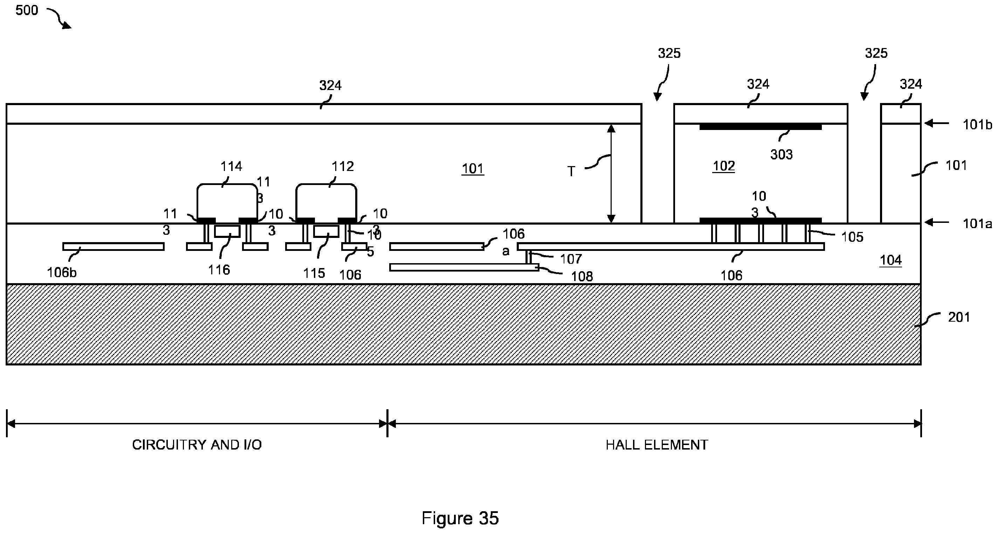

Turning to Fig. 35, trenches 325 are etched from the second surface 101b into the semiconductor substrate 101, which extend to the first surface 101a. The mask 324 for the trench etch is such that the Hall sensor region 102 is laterally confined by the trenches 325. Subsequently the trenches 325 are filled with dielectric material like silicon oxide.

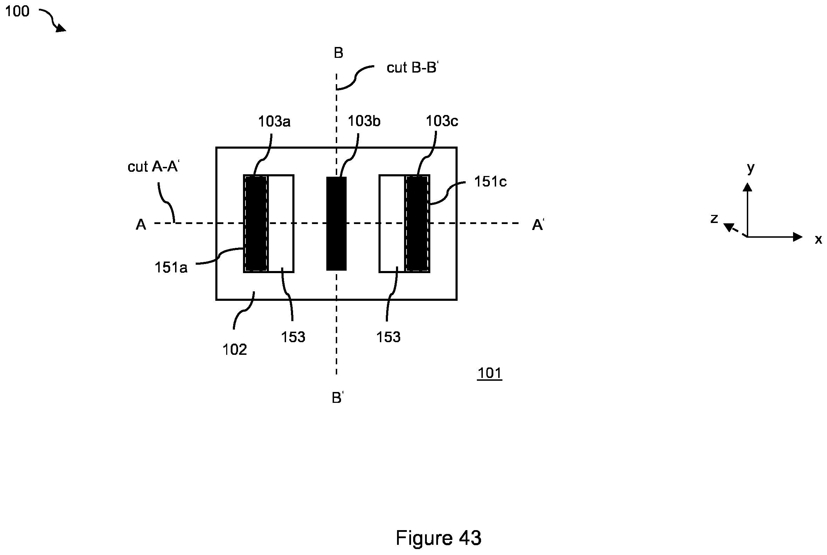

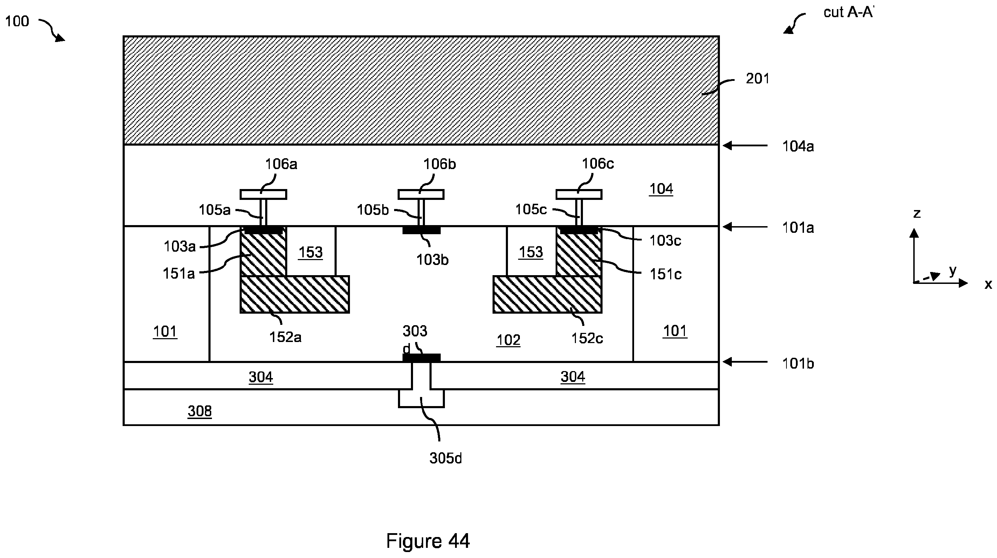

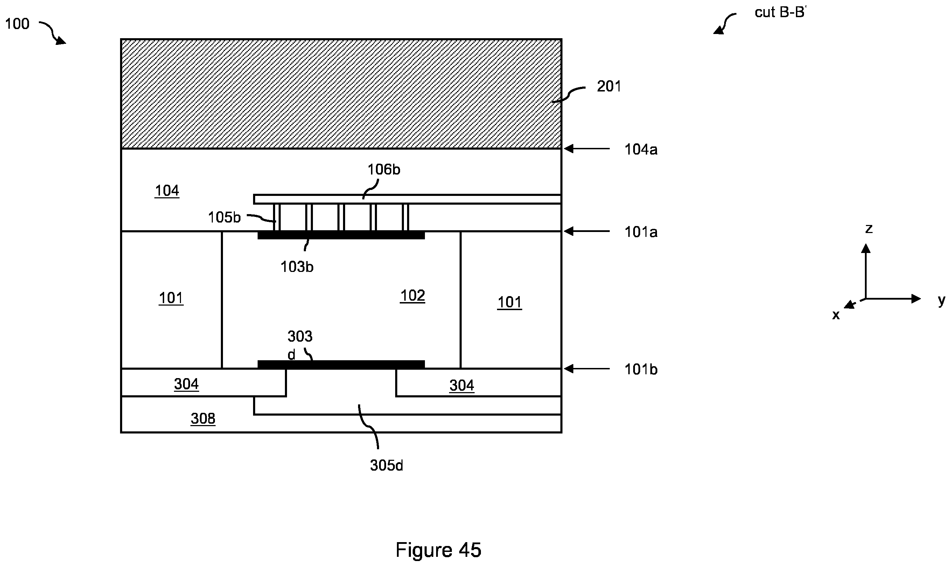

The Fig. 43, 44 and 45 show a second inventive concept of a vertical Hall element 100, NOT ACCORDING TO THE PRESENT INVENTION. In Fig. 43 the vertical Hall element is shown from above, looking on the first silicon surface. Two cuts are indicated, one cut parallel to the x-direction from A to A', and one cut parallel to the y-direction from B to B'. Fig. 44 shows a cross-section of the vertical Hall element 100 along the cut A-A' and Fig. 45 shows a cross-section of the vertical Hall element 100 along the cut B-B'. The vertical Hall element 100 is formed on a semiconductor substrate 101. The semiconductor substrate 101 might be a low doped silicon substrate having the first conductivity type. The first conductivity type is preferably p-type. The substrate has a first surface 101a and a second surface 101b. The two surfaces are opposing and parallel to each other. The second surface 101b is obtained by thinning of the substrate from the backside, i.e. from the side opposite to the first surface 101a. A doping region 102 is formed, which extends from the first surface 101a to the second surface 101b. The doping region 102 has the second conductivity type, i.e. region 102 has n-type conductivity. The region 102 might be doped with Phosphorus and the dopant concentration might be in the range of 1*10¹⁴/cm³ to 1*10¹⁷/cm³. Preferably, the dopant concentration is homogeneous in vertical direction. Two doping regions denoted by 152a and 152c are disposed in well 102. The doping regions 152a and 152c have the second conductivity type. They might be doped by phosphorus and the dopant concentration might be in the range of 1* 10¹⁷/cm³ to 1* 10²¹/cm³.

As depicted in Fig. 44, the doping regions 152a and 152c are buried in region 102. Preferably, the location of the doping regions 152a and 152c in z-direction is approximately half-way between the first surface 101a and the second surface 101b. There are furthermore the wells 103a and 103c having the second conductivity as well. The well 103a extends from the first surface 101a into the doping region 102 reaching out to the buried region 152a. In the same way, the well 103c extends from the first surface 101a into the doping region 102 such that the well 103c is in contact with the buried region 152c. At the first surface 101a shallow highly doped regions 103a, 103b and 103c are formed extending from the first surface into doping region 102. The highly doped regions 103a, 103b and 103c have the second conductivity type. The dopant concentration might be in the range of 1*10¹⁹/cm³ to 1* 10²²/cm³ .

As shown in Fig. 43, the highly doped regions 103a, 103b and 103c are arranged along the x-direction in a row. The doping region 103b is located between doping regions 103a and 103c in such a way that the distance between 103a and 103b and the distance between 103b and 103c are equal. Moreover, the highly doped regions 103a, 103b and 103c are disposed inside of region 102. The highly doped region 103a is arranged inside of the well 151a and the highly doped region l03c is arranged inside of the well 151c.

Turning again to Fig. 44, a dielectric layer 104 is disposed on the first surface 101a. The dielectric layer 104 may comprise several layers of silicon nitride, silicon oxide or low-k dielectrics as typically used in CMOS manufacturing processes. Metal contacts 105a, 105b and 105c are embedded in the dielectric layer 104. The metal contact 105a is placed on the highly doped region 103a achieving an electrical connection to the highly doped region 103a and thus to the well 151a and further to the buried region 152a. The metal contact l05b is placed on the highly doped region 103b achieving an electrical connection to the highly doped region 103b. Furthermore, the metal contact 105c is placed on the highly doped region 103c achieving an electrical connection to the highly doped region l03c and thus to the well 15lc and further to the buried region 152c.

As indicated in Fig. 45, a plurality of metal contacts might be placed on the highly doped region 103b, and similarly, also on the highly doped regions 103a and 103c. In a typical CMOS manufacturing process, a metal silicide might be formed on the highly doped regions 103a, 103b and 103c. The metal contacts 105a, 105b and 105c might consist of tungsten or other suitable metal. In Fig. 43 and 44 a first metal layer is shown being embedded in the dielectric layer 104. In general, a CMOS metallization may comprise several metal layers and vertical interconnects. For simplicity, only one metal layer is shown in Fig. 44 and 45. 106a, 106b and 106c denote metal wires formed by this first metal layer, connecting to metal contacts 105a, 105b and 105c, respectively.

As shown in Fig. 45, the metal wire 106b is oriented along the y-direction. Also, the metal wires 106a and 106c are oriented along the y-direction. A carrier 201 is attached to the top surface 104a of the dielectric layer 104. The carrier 201 might be a silicon wafer. At the second surface 101b of the substrate 101 a fourth shallow highly doped region is formed, which is denoted by 303d. The highly doped region 303d extends from the second surface 101b into the doping region 102.

The doping region 303d has the second conductivity type and a dopant concentration in the range of 1*10¹⁹/cm³ to 1*10²²/cm³. The doping region 303d has the same but opposite location of the doping region l03b. More precisely, if a connecting line is drawn from the center of the doping region 103b at the first surface 101a to the center of the doping region 303d at the second surface 101b, then this connecting line is perpendicular to the surfaces 101a and 101b. A dielectric layer 304 is disposed on the second surface 101b. The dielectric layer may consist of silicon oxide. A metal contact 305d is formed in the dielectric layer 304 such that an electrical connection is established to the highly doped region 303d.

The metal contact 305d may extend to a metal wiring formed on the dielectric layer 304 as shown in Fig. 43 and 44. The metal wiring is oriented parallel to the y-direction as indicated in Fig 44. Metal contact and wiring 305b might consist of aluminium. Alternatively, the contact hole formed in the dielectric layer 304 might be filled with tungsten. In that case, the wiring part of 305d disposed on the dielectric layer 304 might consist of aluminium or copper. Other metallization schemes could be conceived as well. A passivation layer 308 is disposed on metal wire 305d and dielectric layer 308.

The passivation layer 308 might consist of silicon oxide, silicon nitride, silicon oxynitride or a layered stack of these materials. In the embodiment shown in Fig. 43, 44 and 45, there are in addition the doping wells 153, which extend from the first surface 101a into the doping region 102. The two doping wells 153 are placed each between the highly doped region 103b in the center and the two highly doped regions 103a and 103c on left and on the right side, respectively. As depicted in Fig. 41 and 42, the two doping wells 153 might each be butted to the wells 151a and 151c, respectively. The wells 153 might have a similar depth as the well 151a and 151c and might, as shown in Fig. 43, reach down to the buried doping regions 152a and 152c. The doping wells 153 have the first conductivity type.

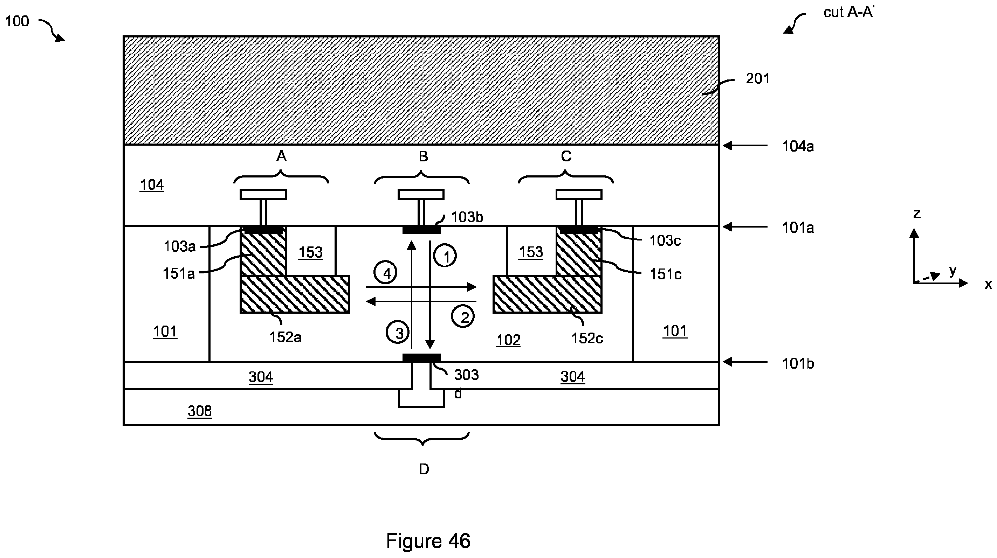

In the following reference is made to Fig. 45 showing again the vertical Hall element 100 in cut direction B-B'. The doping region 102 constitutes the Hall sensor region or Hall plate of the vertical Hall element 100. The doping region 102 is laterally, i.e. in x- and in y-direction bounded by a p-n junction formed with the substrate 101 having the reverse polarity of well 102. In the following reference is made to Fig. 46 showing again the vertical Hall element 100 in cut direction A- A', NOT ACCORDING TO THE PRESENT INVENTION. The vertical Hall element 100 has four Hall terminals, which are indicated by the capital letters A, B, C and D. The Hall terminal B is arranged on the first surface 101a. From an operation point of view, the terminal B of the vertical Hall element 100 is defined by the spatial dimensions of the highly conductive region 103b. The Hall terminal D is arranged on the first surface 101b opposite to terminal B. Again, from an operation point view the terminal D of the vertical Hall element 100 is defined by the spatial dimensions of the highly conductive region 303d. The Hall terminal A comprises the highly conductive buried region 152a with the well 151a providing a connection to the first surface, where terminal A is accessed via highly doped region 103a and metal contacts placed thereon. In the same way, the terminal C comprises the highly conductive buried region 152a with the well 151c providing a connection to the first surface 101a, where the terminal C is accessed via highly doped region 103c and metal contacts placed thereon. The wells 153, which have the reverse polarity of the doping regions 102, 151a, 152a, 151c and 152c, serve to shield the active sensor region between the four Hall terminals electrostatically from the wells 151a and 151c.

In Fig. 46 four arrows are drawn, indicated by the numbers 1, 2, 3 and 4. Each arrow represents the direction of the operating current driven through the Hall sensor region. The four arrows are thus representative of the four possible operations modes or phases of the vertical Hall element. Starting with operation mode 1, a current is forced between terminals B and D flowing in the direction from terminal B to terminal D. In this mode, a Hall voltage is acquired between terminal C and terminal D, which is indicative of a magnetic field component pointing in y-direction. In operation mode 2, a current is forced between terminal C and A flowing in direction from terminal C to terminal A. A Hall voltage is acquired between terminals B and C, which is again indicative of a magnetic field component pointing in y-direction. The operation mode 3 corresponds to operation mode 1 with the difference that the current direction is reversed, and the Hall voltage is required between terminal D and C. Similarly, the operation mode 4 corresponds to operation mode 2 with the current direction reversed and the terminals B and D commutated with respect to operation mode 2. Owing to the terminal D placed at the second surface 101b, a current can be forced through the Hall element 100, which is essentially flowing vertically through the Hall sensor region 102. Owing to the highly conductive regions l52a and l52c being buried in doping region 102, a current can be forced through the Hall sensor element, which is essentially flowing parallel to the first surface 101a at a certain depth being determined by the depth of the highly conductive regions 152a and 152c.

The specific Hall terminal configuration of vertical Hall element 100 with two buried terminals (A and C), one terminal on first surface 101a (B) and one terminal on second surface 101b (D) allows in principle to achieve a higher voltage-related sensitivity than can be obtained typically in a conventional vertical Hall element with all terminals arranged on the primary surface of the substrate.

As is also obvious for a skilled person, the vertical Hall element 100 can be designed such that the offset, i.e. the Hall voltage measured at zero magnetic field, is low for each of the four operation modes. Important design parameters are the thickness of the substrate 101 (the distance between the first surface 101a and the second surface 101b), the depth of the highly conductive regions 152a and 152b, the lateral spacing the depth of the highly conductive regions 152a and l52b, and the spatial dimensions of the highly doped regions 103b and 303d. As already indicated, the highly doped regions 103a, 103b and 103c are arranged along the x-direction in a row with highly doped region 103b placed in the middle between highly doped regions 103a and 103c. The highly doped region 303d has the same but opposite location as the highly doped region 103b. A skilled person will understand that there are more design parameters with respect to layout and doping conditions that can optimized towards achieving a low offset values in the four operation modes. The methods of optimization such as TCAD simulation and design of experiment are known in the art. As a result, a nearly four-fold symmetry is obtained with respect to the four terminals, resulting in low offset values for the four operation modes. As is known in the art, the offset can further be reduced by averaging over the four operation modes. Current spinning and orthogonal coupling of two or four Hall elements are known techniques, which are regularly adopted in the industry and which could be applied to the vertical Hall element 100 as well.

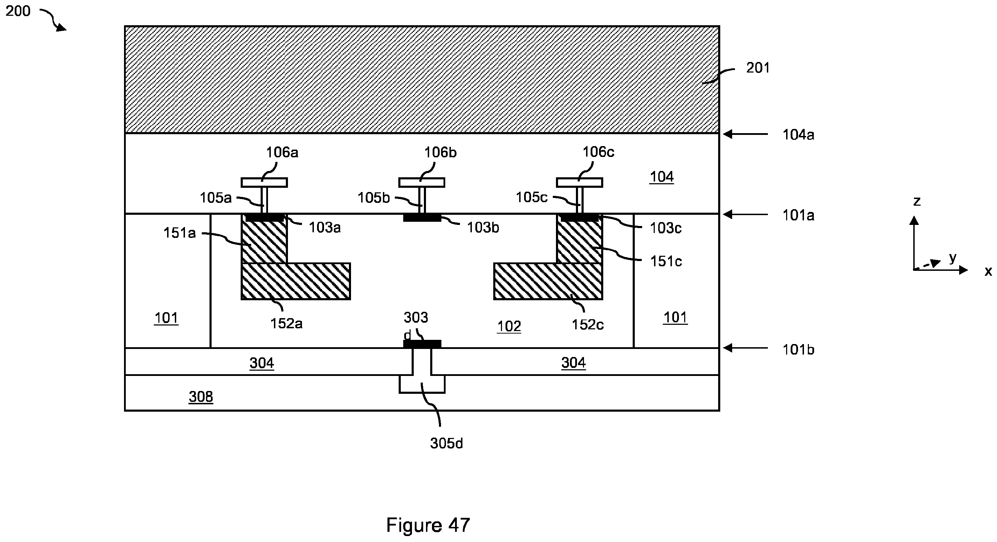

In Fig. 47, the vertical Hall element 200 is shown, which represents another inventive concept, NOT ACCORDING TO THE PRESENT INVENTION. The Hall element 200 differs from the Hall element only in that the shielding wells 153 are missing.

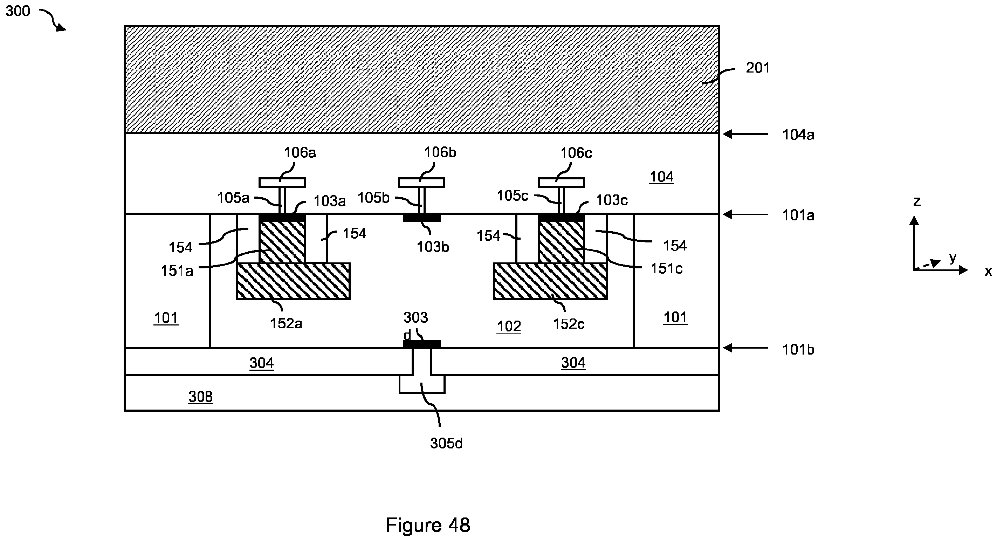

Another inventive concept NOT ACCORDING TO THE PRESENT INVENTION is presented in Fig. 48 showing the vertical Hall element 300 in a cut along the x-direction. The connecting wells 151a and 151c are surrounded each by a dielectric structure denoted by 154. The dielectric structure 154 might have a similar depth as the well 151a and 151c. The well 151a might laterally (i.e. in the x-y-plane) be enclosed by the dielectric structure 154 and, in the same fashion, the well 151c might laterally be enclosed by a second dielectric structure 154. The dielectric structure may consist of silicon oxide or another dielectric material. The dielectric structure 154 might also be a trench having a liner consisting of dielectric material such as silicon oxide and further being filled with poly-silicon. The dielectric structure 154 enhances the shielding of the wells 151a and 151c strengthening the buried character of terminals A and C.

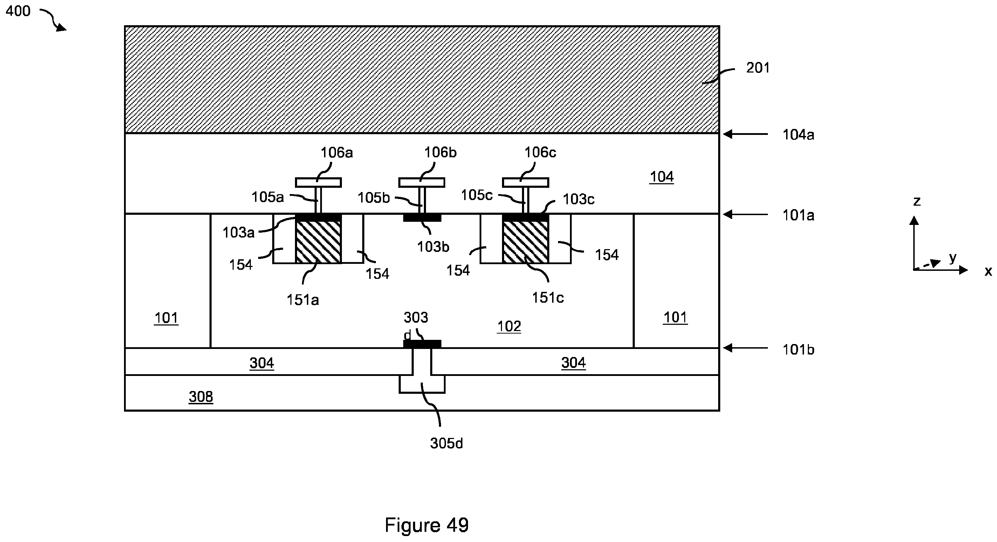

Another inventive concept NOT ACCORDING TO THE PRESENT INVENTION is presented in Fig. 49. The vertical Hall element 400 differs from the vertical Hall element 300 by the fact that the buried regions 152a and 152c are missing. In this embodiment, buried terminals A and C are defined by the wells 151a and 151c, respectively. The wells 151a and 151c are enclosed each by the dielectric structures 154. Thus, the wells 151a and 151c are in electrical contact with the Hall sensor region 102 only at their bottom surfaces.

Compared to the vertical Hall element 300, the depth of the wells 151a and 151c, and accordingly also the depths of the dielectric structures 154, is increased.

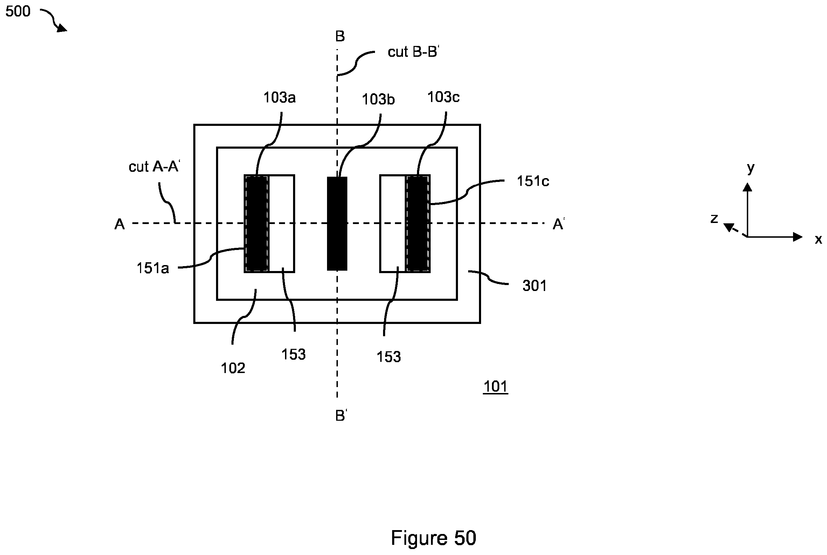

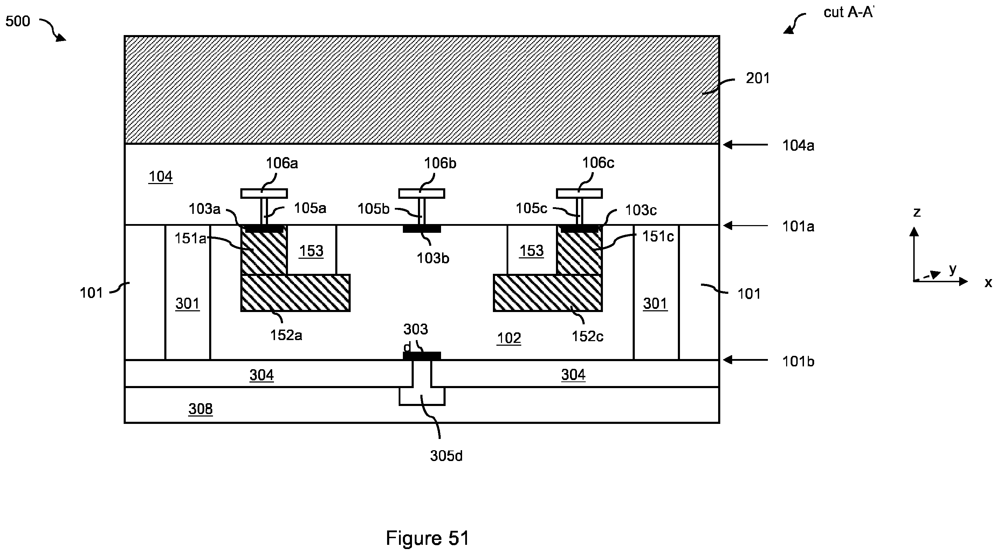

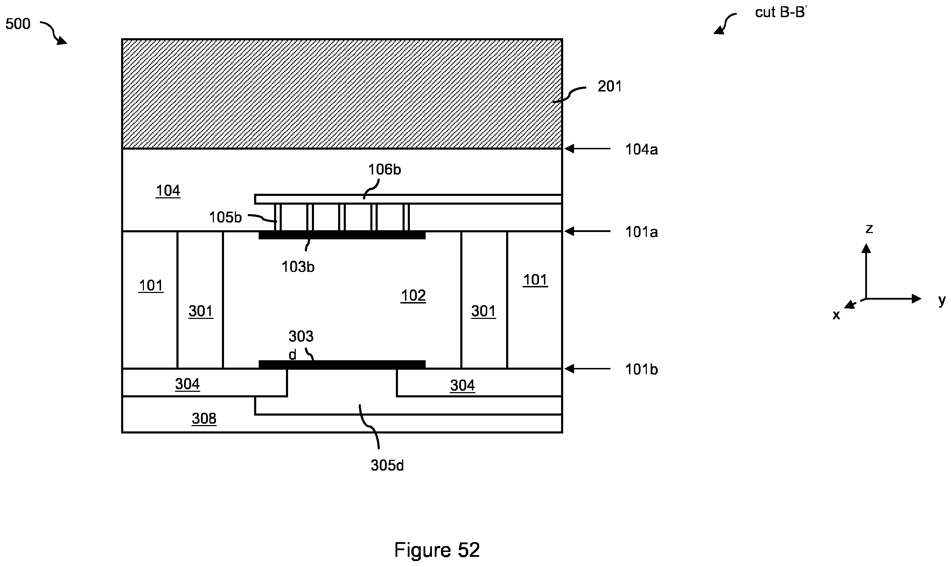

Another inventive concept NOT ACCORDING TO THE PRESENT INVENTION is given in conjunction with Fig. 50, 51 and 52. The vertical Hall element 500 differs from the vertical Hall element 100 in that doping region 102 establishing the Hall sensor region is separated by a deep trench isolation structure 301 from the substrate 101. In z-direction the deep trench isolation structure 301 extends from the first surface 101a to the second surface 101b of the substrate 101 as shown in Fig. 51 and 52.

Referring to Fig. 50, the doping region 102 is in x- and y-direction enclosed by the deep trench isolation structure. The enclosure is such that the doping region 102 extends in x- and y-direction everywhere to the deep trench isolation structure 301. Inside of the deep trench isolation structure 301 the well 102 has no boundary with substrate 101.

During operation of a Hall element, when a current is driven through the Hall sensor region, depletions zones are formed along all p-n junctions delimiting the Hall sensor region. As the Hall sensor region 102 of vertical Hall element 500 has no p-n junction boundary with the surrounding substrate 101 anymore, no depletion zones can be formed at this boundary anymore. However, depletion zones are formed during operation of the vertical Hall element 500 along the shielding wells 153, which have the first conductivity. In another embodiment, not shown in a figure, the shielding wells 153 in the vertical Hall element 500 are removed and substituted by a dielectric isolation structure 154 like in the vertical Hall element 300. In this embodiment the Hall sensor region 102 is not bounded at any instance by a p-n junction anymore.

Depletions zones formed at the boundaries of the Hall plate during operation of the Hall element change the resistance of the Hall plate affecting sensitivity and offset. Since the width of the depletion zones is a function of the operating current, the Hall element will display a non-linear behaviour. This non-linearity increases the calibration effort and the associated cost.

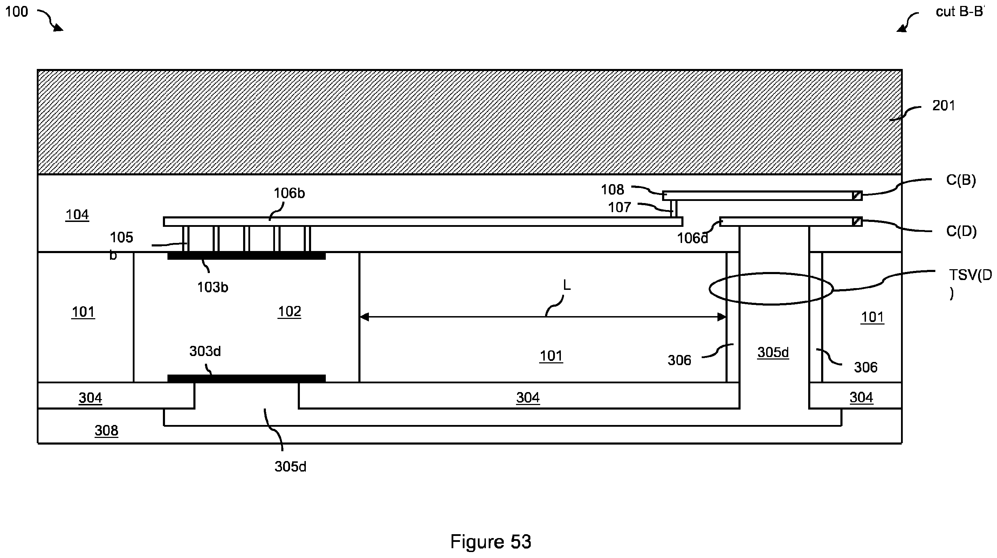

Figure 53 is another representation the vertical Hall element 100 along the cut direction B-B'. To complement Fig. 45, a through silicon via (TSV) is depicted on the right side of Figure 53. The through silicon via provides a vertical conductive path through the substrate 101 connecting the highly doped region 303d disposed on the second surface 101b and representing terminal D to the metal wiring formed on the first silicon surface. The through silicon via associated with the terminal D is denoted by TSV(D). The through silicon via TSV(D) is in contact with the portion l06d of the first metal layer embedded in the dielectric layer 104. At the second surface 101b, the through silicon via TSV(D) is connected to the terminal D by the metal wiring 305d. In this way, the terminal D can be accessed at the point C(D). The terminal B formed on the first surface 101a can be accessed electrically at point C(B). The through silicon via is filled with a conductive material 305d which could be the same material which is used for the metallization on the second surface. The conductive filling 305d of the through silicon via is isolated from the silicon substrate 101 by the dielectric liner 306 disposed onto the inner surfaces of the through silicon via. The through silicon via is placed at a distance L from the well 102 in which the Hall terminals are formed. A current I driven through the through silicon via gives rise to a magnetic field parallel to the silicon surface. The strength of the induced magnetic field at the location of the vertical Hall element is B = µ₀/(2πL)·I. To minimize this perturbing effect, the distance L can be set large enough. For instance, if the Hall current is 1mA and the distance L is set to 100µm, the induced magnetic field strength is 2µT, which is well below the measurement resolution of available vertical Hall elements.

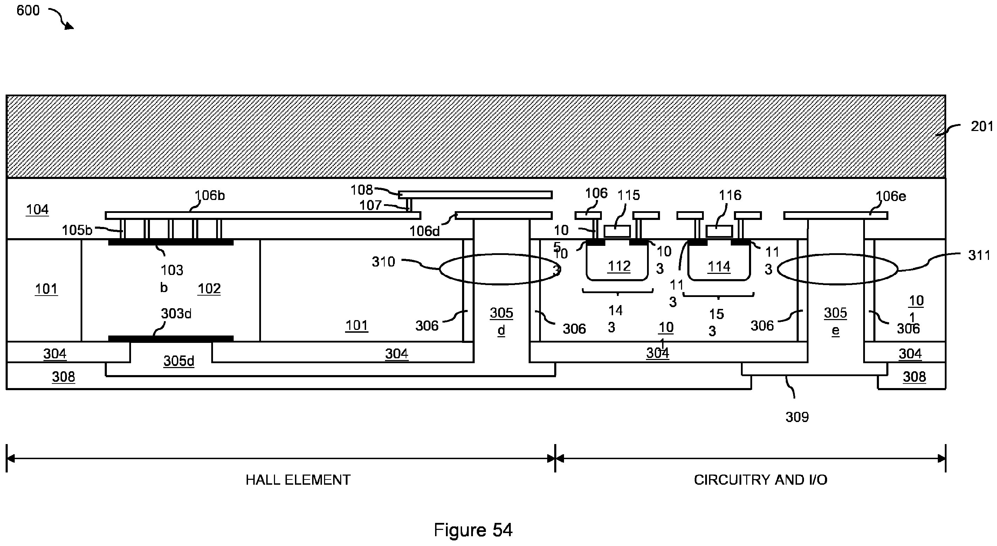

Figure 54 show a third embodiment of a semiconductor device 600 comprising a vertical Hall element.

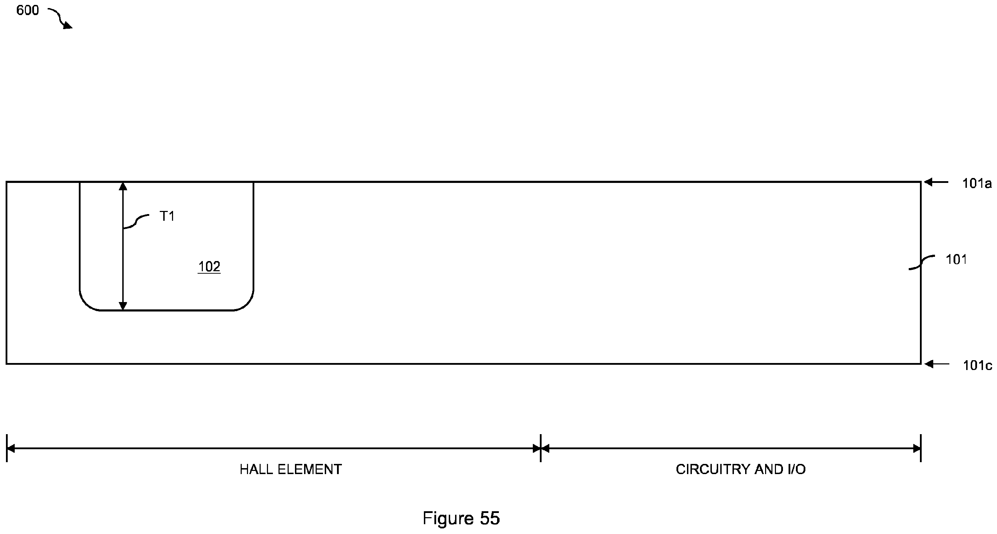

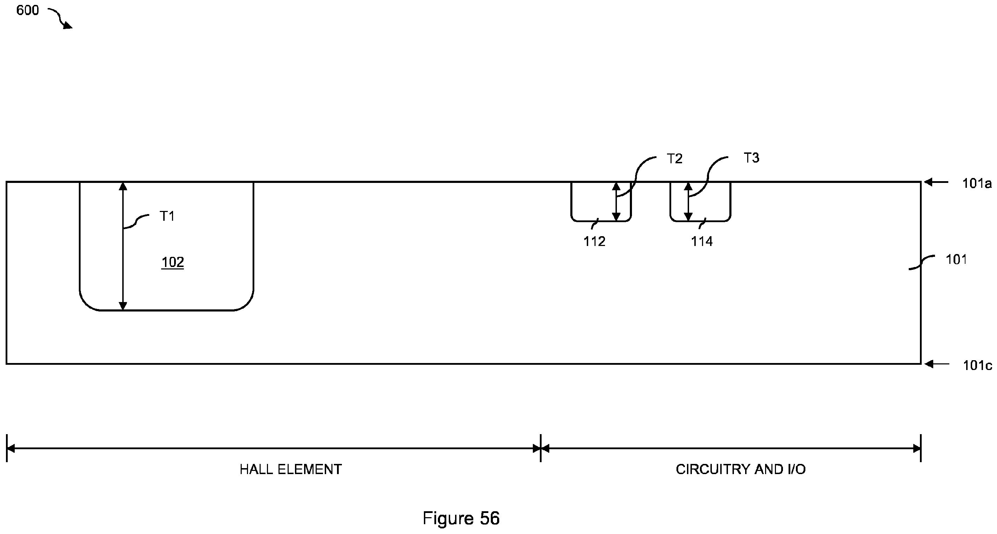

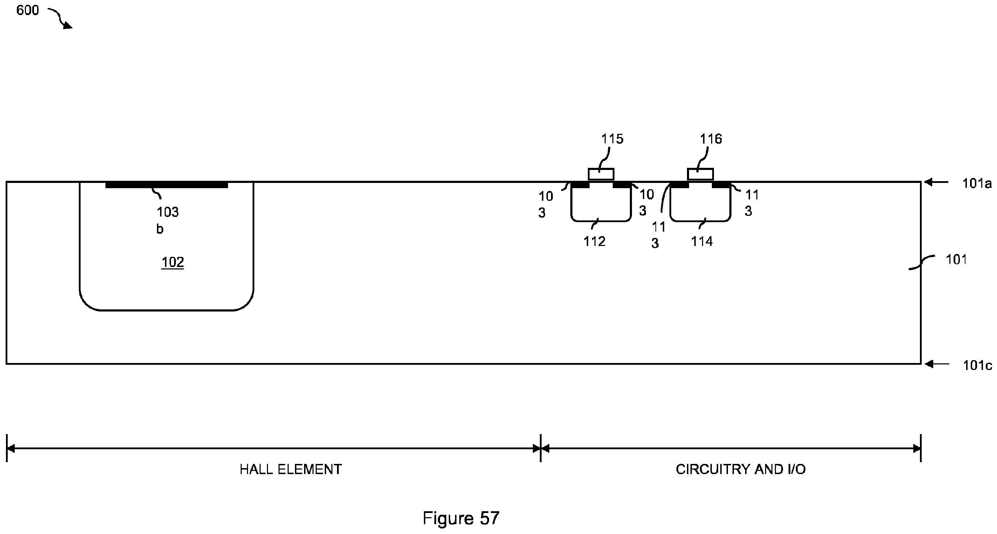

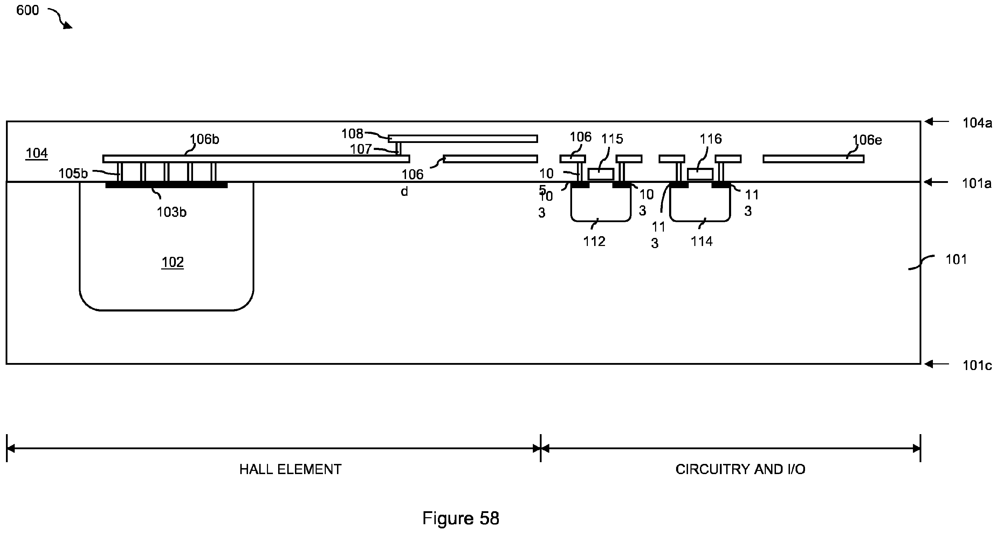

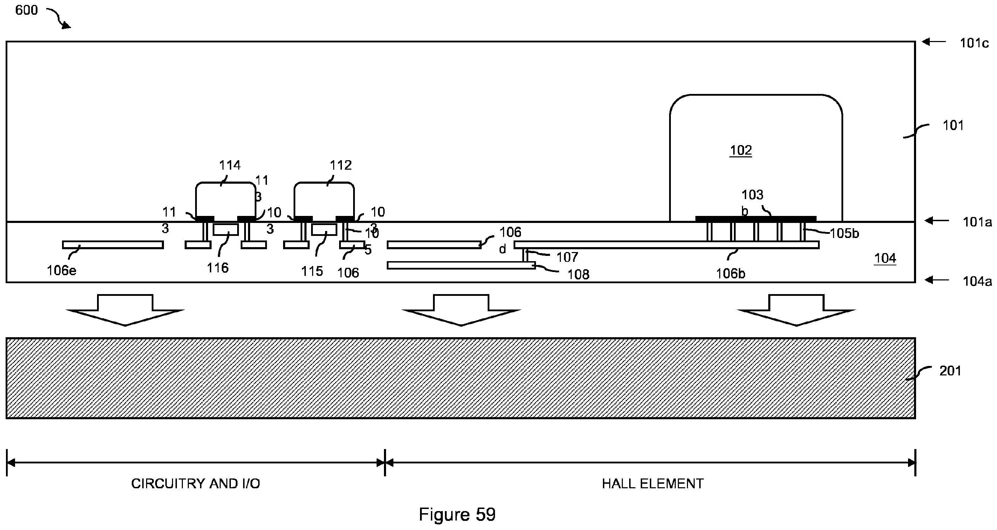

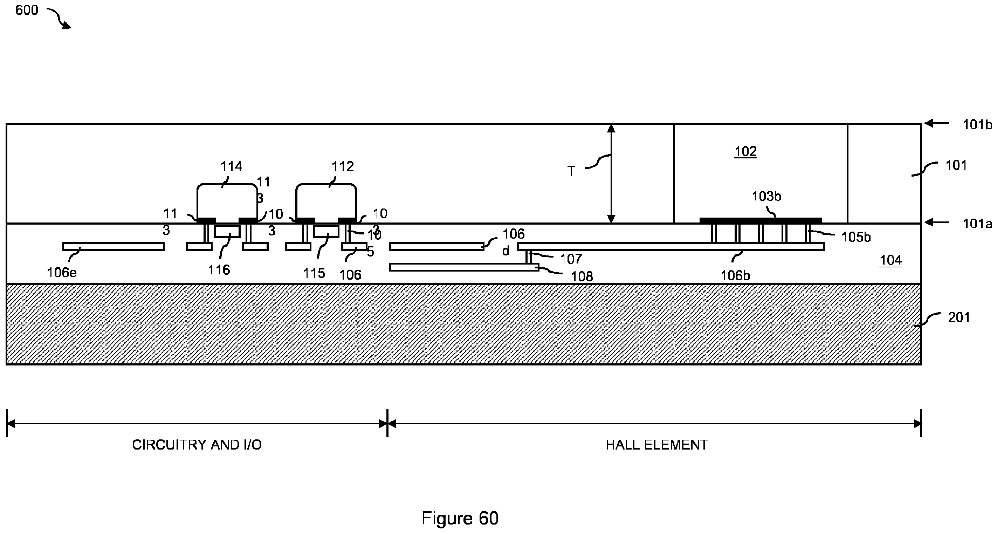

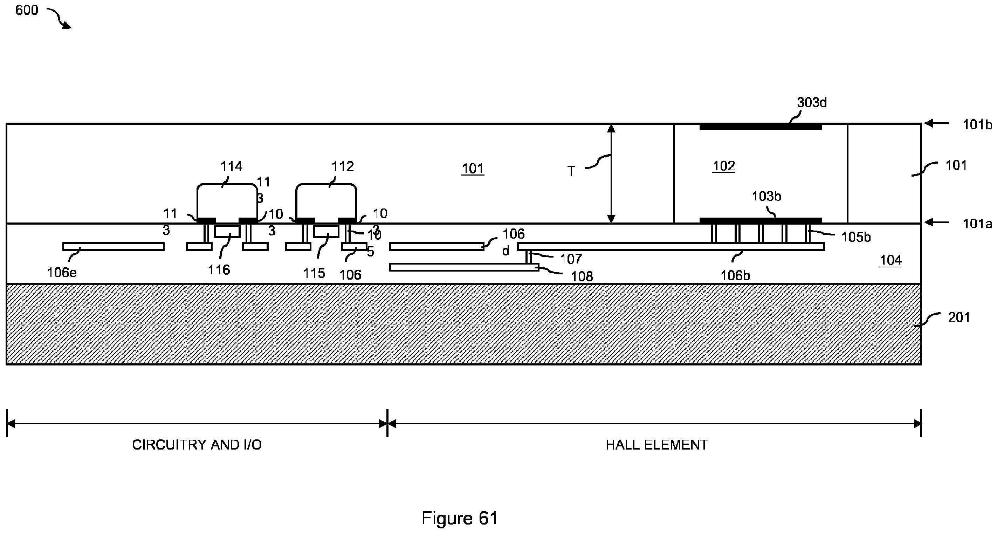

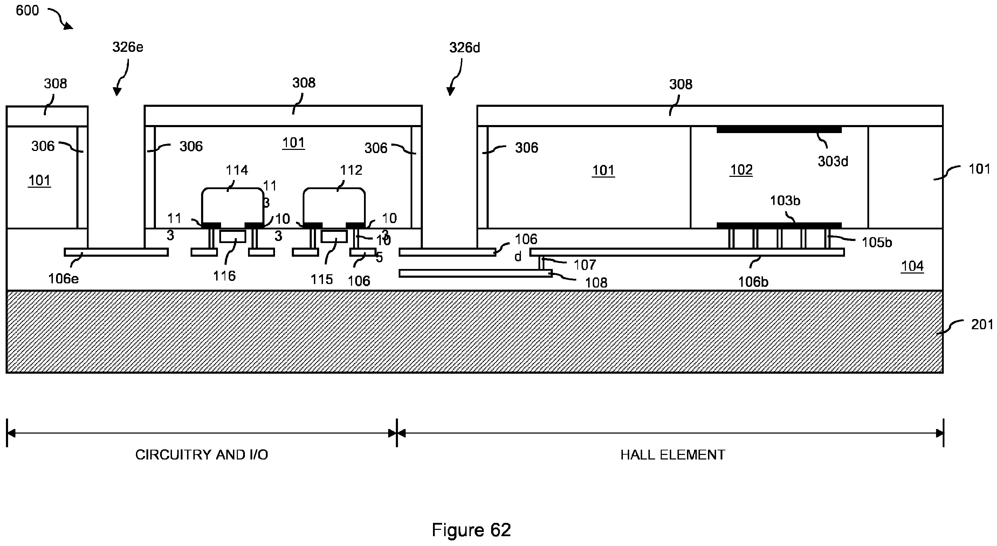

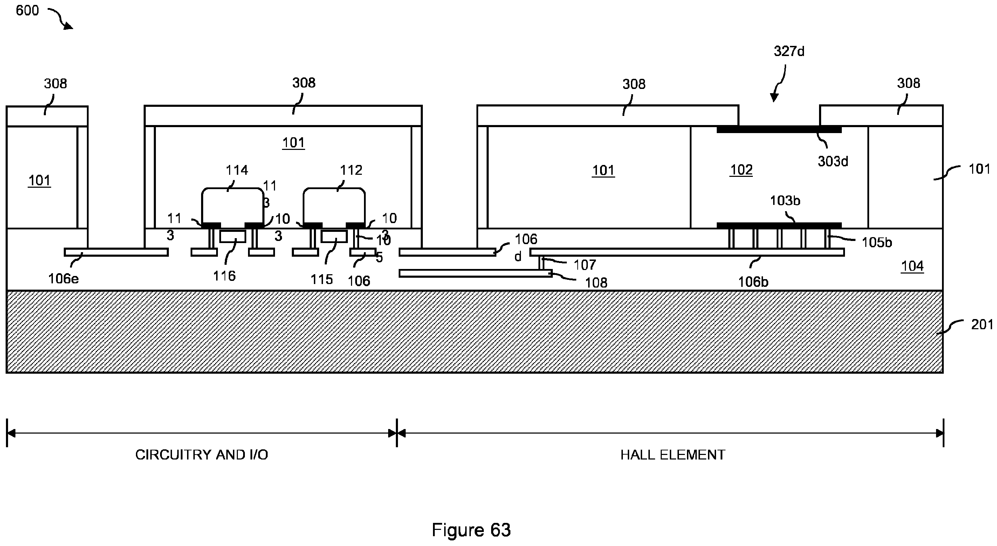

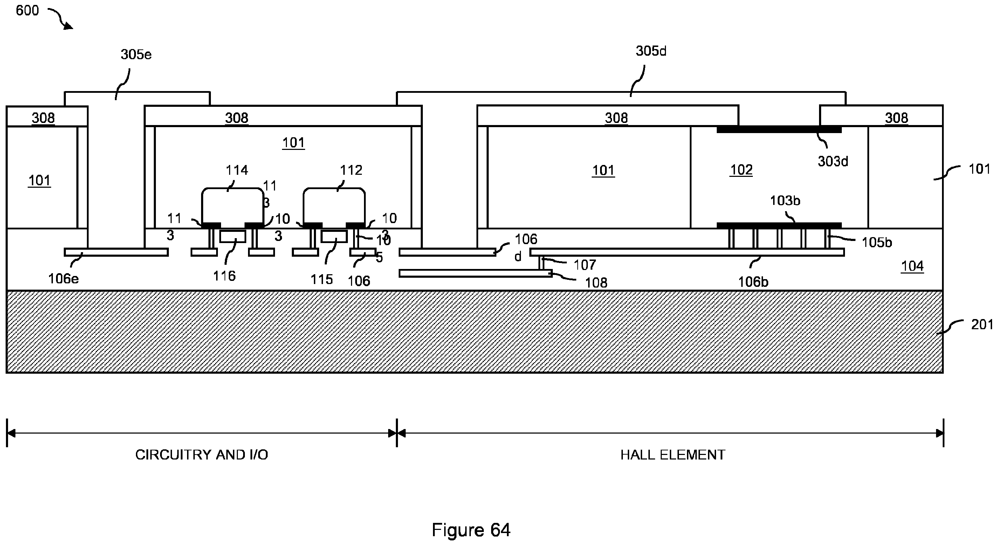

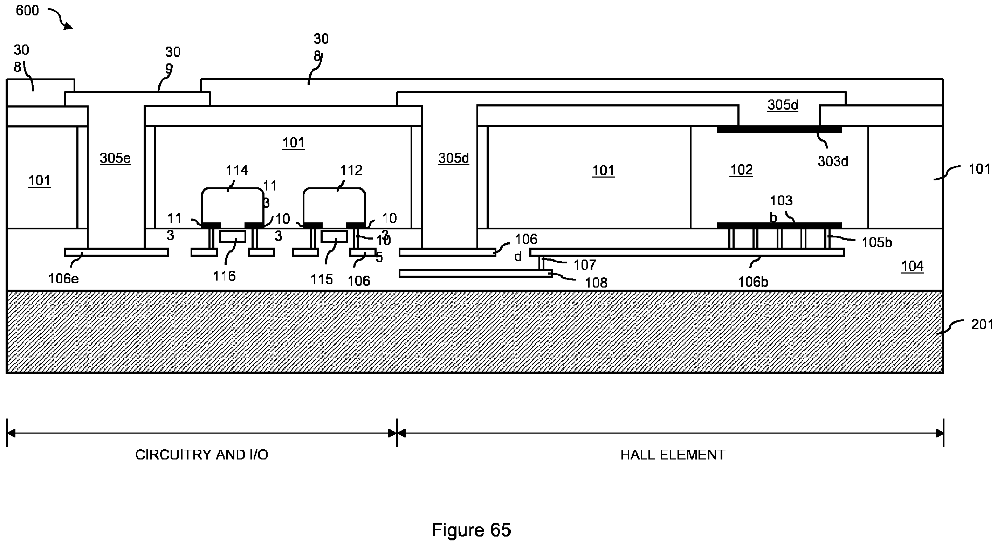

Figures 55 to 65 illustrate manufacturing steps of a method of manufacturing the third embodiment of a semiconductor device 600 comprising a vertical Hall element. The basic manufacturing steps are explained in EP 2913847 A1.

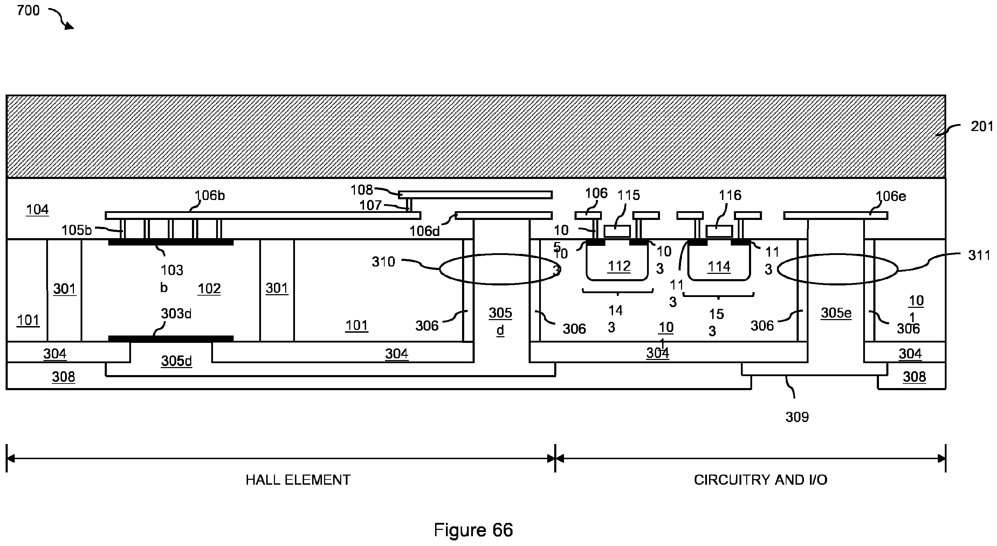

Figure 66 show a fourth embodiment of a semiconductor device 700 comprising a vertical Hall element.

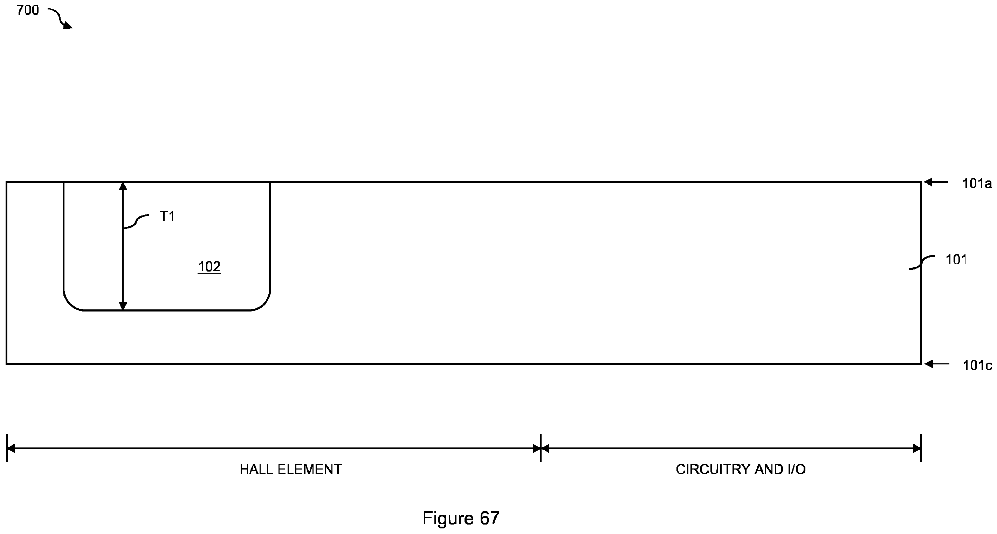

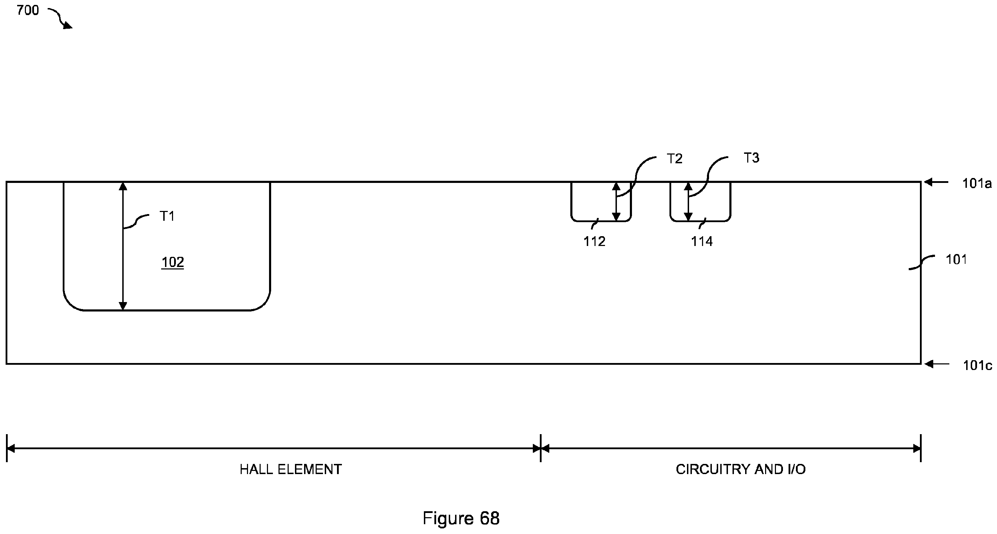

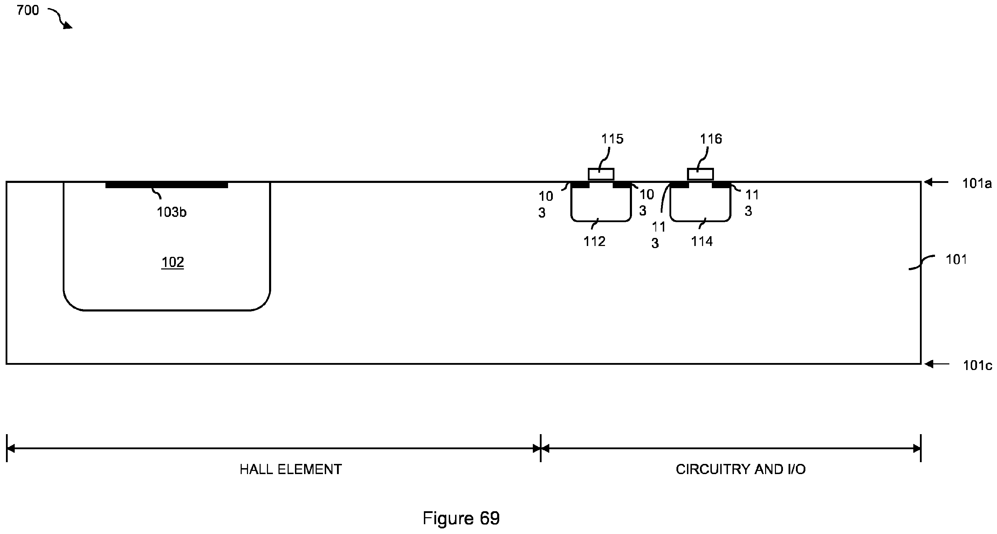

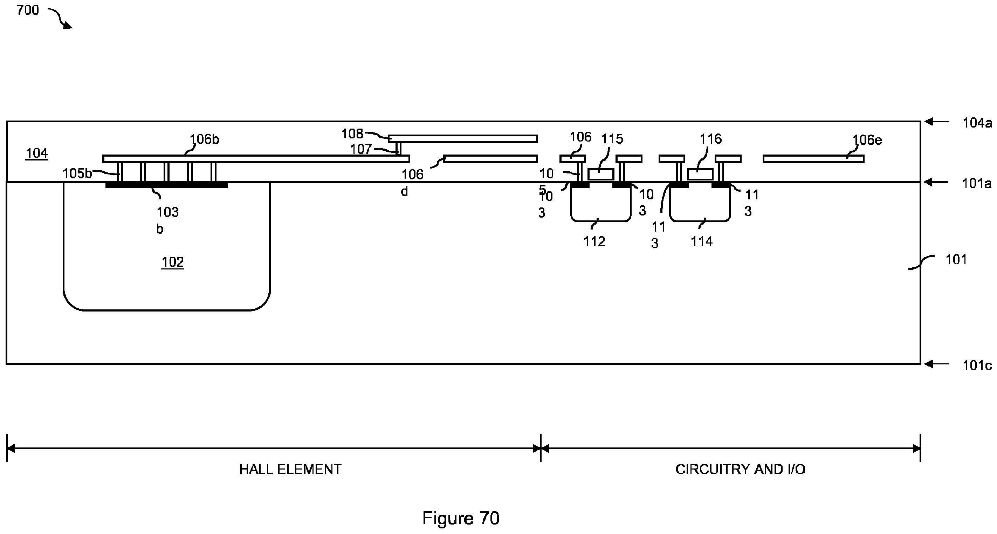

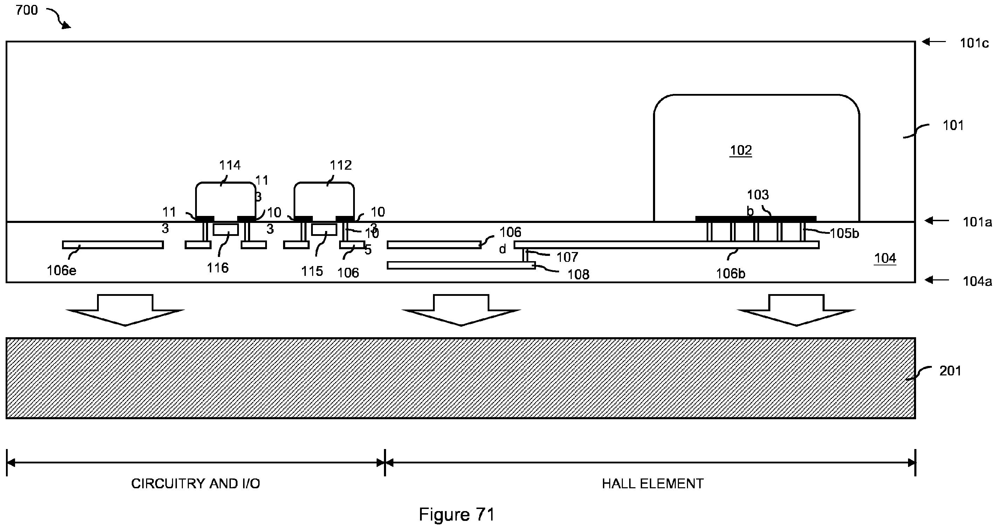

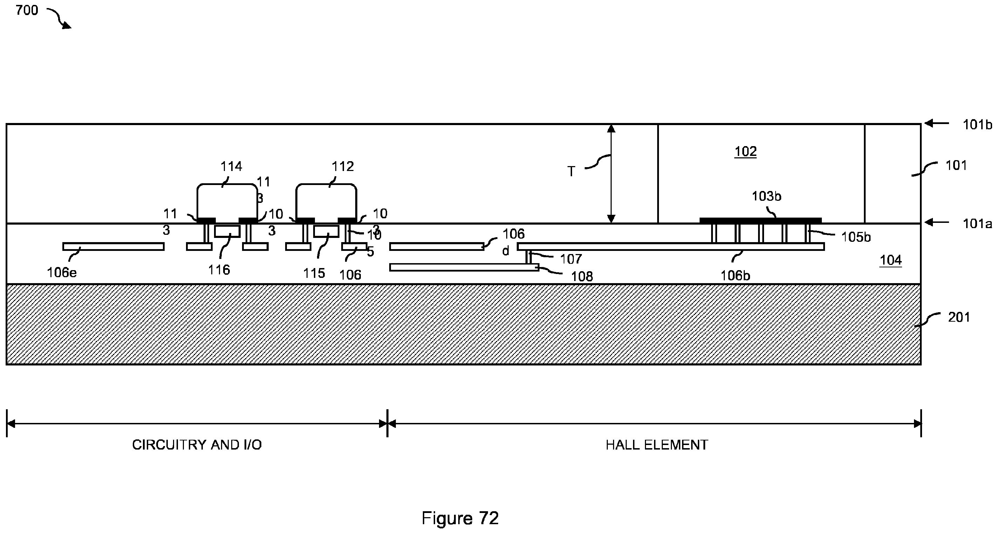

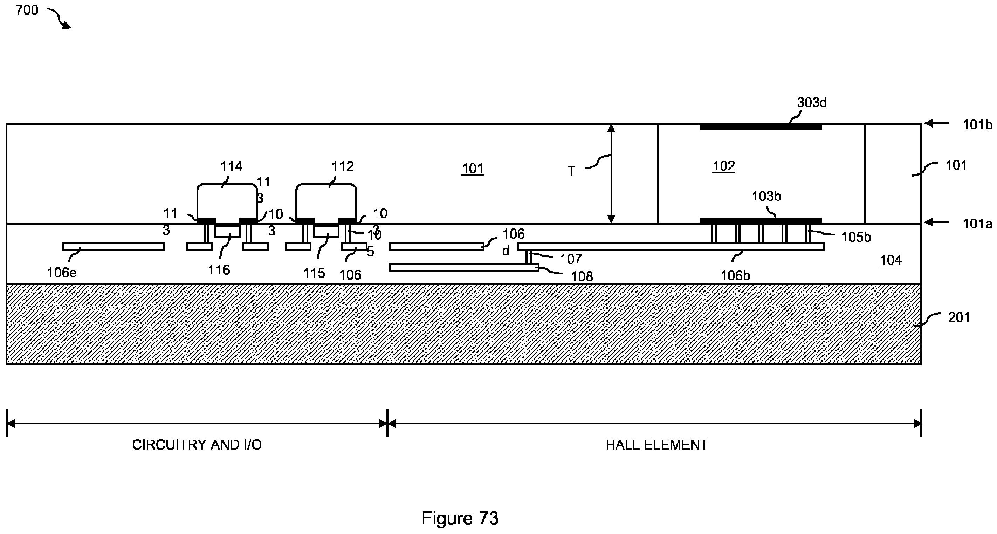

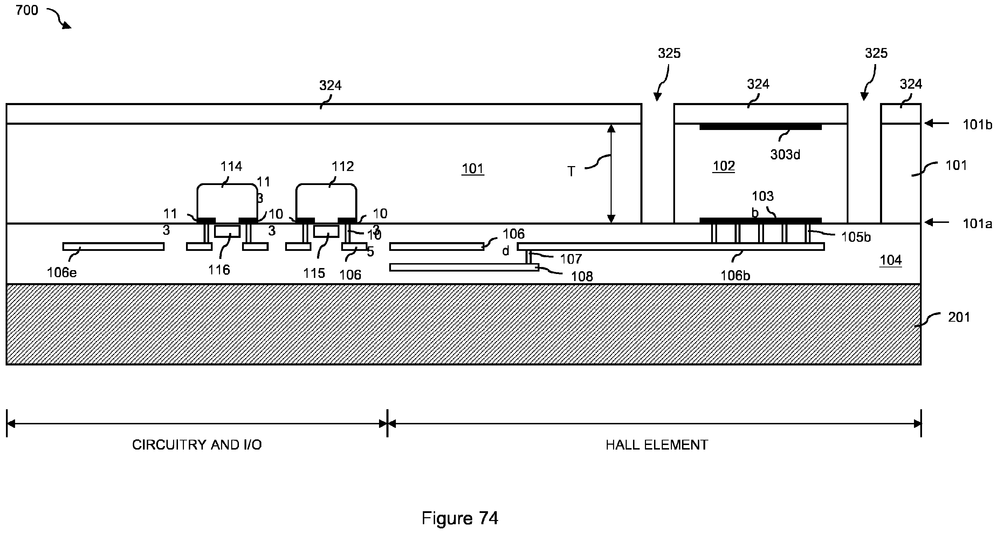

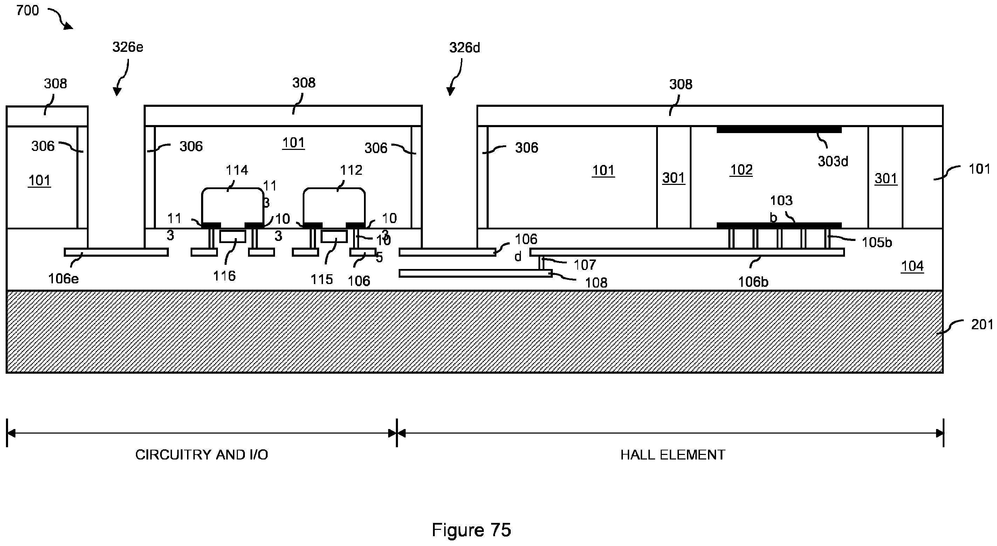

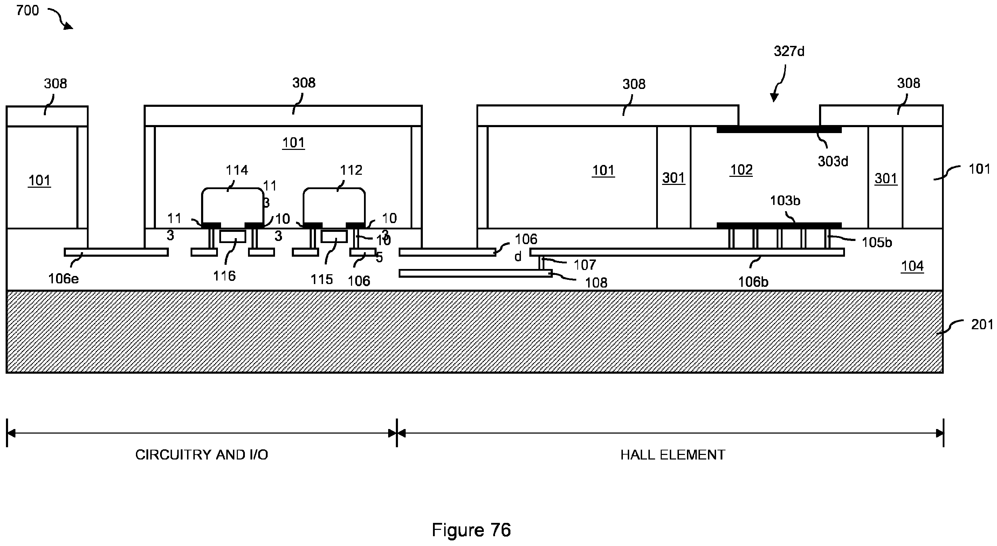

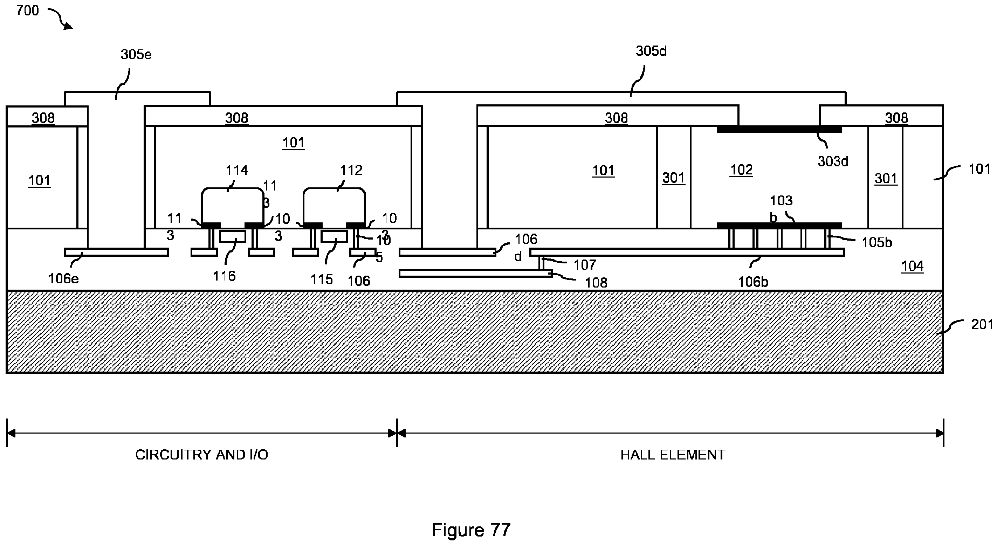

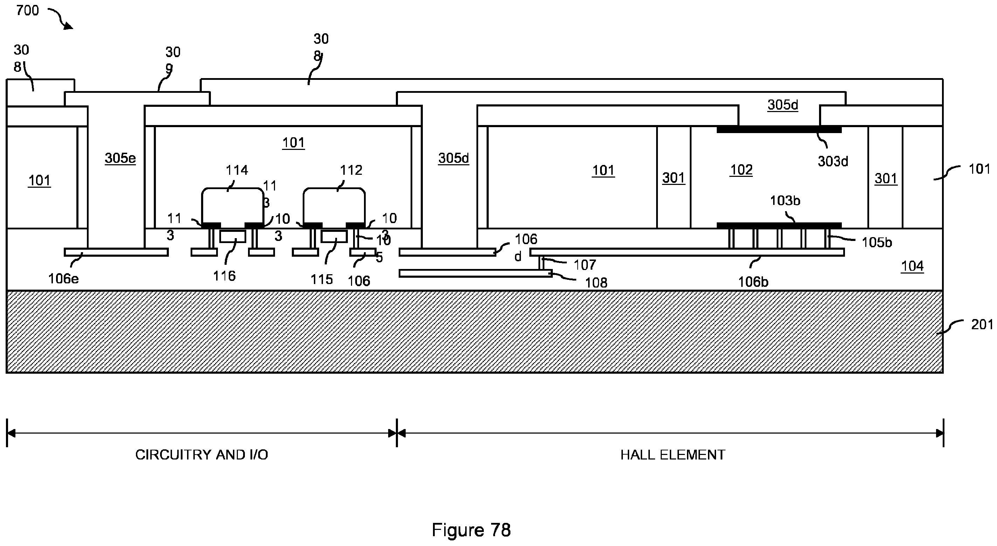

Figures 67 to 78 illustrate manufacturing steps of a method of manufacturing the fourth embodiment of a semiconductor device 700 comprising a vertical Hall element.

## Claims

1. A vertical Hall element (100, 200, 300, 400, 500, 600, 700), comprising:
- a substrate (101) of a first conductivity type having a first surface (101a) and a second surface (101b);
- a well (102) being disposed in the substrate (101), the well (102) having a second conductivity type, wherein the well (102) is exposed both on the first surface (101a) and on the second surface (101b) of the substrate (101);
- at least two terminals (1, 2) arranged on the first surface (101a) of the substrate (101) and being in contact with the well (102), and at least two terminals (3, 4) arranged on the second surface (101b) of the substrate (101) and being in contact with the well (102), wherein the at least two terminals (3, 4) on the second surface (101b) of the substrate (101) are disposed in an orthogonal projection on the substrate (101) below the at least two terminals (1, 2) on the first surface (101a) of the substrate (101);
- a dielectric layer (104) being disposed on the first surface (101a) of the substrate (101);
- a wiring (105, 106, 107, 108) being embedded in the dielectric layer (104); and
- a through silicon via (TSV) filled with a conductive filling (305) that provides a vertical conductive path through the substrate (101) for connecting one of the third and fourth terminals (3, 4) to the wiring in the dielectric layer (104).

2. The vertical Hall element of claim 1,
- wherein the at least two terminals (1, 2) on the first surface (101a) of the substrate (101) comprises a first terminal (1) and a second terminal (2) being arranged next to each other on the first surface (101a) of the substrate (101),
- wherein the at least two terminals (3, 4) on the second surface (101b) of the substrate (101) comprises a third terminal (3) and a fourth terminal (4) being arranged next to each other on the second surface (101b) of the substrate (101),
- wherein the fourth terminal (4) is located directly below the first terminal (1) such that a virtual straight line between a center of the first terminal (1) and a center of the fourth terminal (4) is perpendicular to first and second surface (101a, 101b) of the substrate (101),
- wherein the third terminal (3) is located directly below the second terminal (2) such that a virtual straight line between a center of the second terminal (2) and a center of the third terminal (3) is perpendicular to first and second surface (101a, 101b) of the substrate (101).

3. The vertical Hall element of claim 1 or 2,
wherein each of the at least two terminals (1, 2) on the first surface (101a) of the substrate (101) comprises a shallow and highly doped region (103) extending from the first surface (101a) into the substrate (101), the highly doped region (103) having the second conductivity type.

4. The vertical Hall element of any of the preceding claims,
wherein the at least two terminals (1, 2) on the first surface (101a) of the substrate (101) are connected with a first metal layer (106) of the wiring embedded in the dielectric layer (104).

5. The vertical Hall element of any of the preceding claims, comprising:
a carrier substrate (201) being bonded to a top surface (104a) of the dielectric layer (104), wherein the top surface (104a) of the dielectric layer (104) is opposite to a surface of the dielectric layer disposed on the first surface (101a) of the substrate (101).

6. The vertical Hall element of any of the preceding claims,
wherein each of the at least two terminals (3, 4) on the second surface (101b) of the substrate (101) comprises a shallow and highly doped region (303) extending from the second surface (101b) into the substrate (101), the highly doped region (303) having the second conductivity type.

7. The vertical Hall element of claim 6, comprising:
- a second dielectric layer (304),
- a passivation layer (308),
- wherein the second dielectric layer (304) is disposed on the second surface (101b) of the substrate (101) and the passivation layer (308) is disposed on the dielectric layer (304).

8. The vertical Hall element of any of the preceding claims,
wherein the conductive filling (305) of the through silicon via (TSV) is isolated from the substrate (101) by a dielectric liner (306) disposed onto an inner surface of the through silicon via (TSV).

9. The vertical Hall element of any of the preceding claims, comprising:
a deep trench isolation structure (601) extending from the first surface (101a) of the substrate (100) to the second surface (101b) of the substrate so that the well (102) is isolated from the substrate (101) by the deep trench isolation structure (601).

10. The vertical Hall element of any of the preceding claims,
wherein the vertical Hall element is configured as a circular vertical Hall element, the well (102) being formed as a ring-shaped well, the vertical Hall element having a plurality of the at least two terminals (1, 2, ..., N) located on the first surface (101a) of the substrate (101) on a first circle and being in contact with the well (102), and a plurality of the at least two terminals (1', 2', ..., N') located on the second surface (101b) of the substrate (101) on a second circle and in contact with the well (102), wherein a respective one of the plurality of the at least two terminals (1', 2', ..., N') on the second surface (101b) of the substrate (101) is disposed in an orthogonal projection on the substrate (101) below a respective one of the plurality of the at least two terminals (1, 2, ..., N) on the first surface (101a) of the substrate (101).

11. The vertical Hall element of claim 10, comprising:
two ring-shaped isolation structures (301a, 301b), the two ring-shaped isolation structures (301a, 301b) extending from the first surface (101a) of the substrate (101) to the second surface (101b) of the substrate (101) and being concentric with the ring-shaped well (102) so that the well (102) is laterally enclosed by the two ring-shaped isolation structures (301a, 301b) and isolated from the substrate (101).

12. A semiconductor device, comprising:
- the vertical Hall element of any of the claims 1 to 11,
- a circuitry to operate the vertical Hall element, wherein the circuitry is configured as an integrated circuit being formed in the substrate (101).

13. The semiconductor device of claim 12,
- wherein the circuitry comprises:
- a bonding pad (309) formed on the second surface (101b) of the substrate (101),
- a through silicon via (311) to provide a connection between the bonding pad (309) and a wiring (106b) disposed in the dielectric layer (104) on the first surface (101a) of the substrate (101).

## Patentansprüche

1. Vertikales Hall-Element (100, 200, 300, 400, 500, 600, 700), umfassend:
° ein Substrat (101) einer ersten Leitfähigkeitsart mit einer ersten Oberfläche (101a) und einer zweiten Oberfläche (101b);
° eine in das Substrat (101) angeordnete Schacht (102), wobei die Schacht (102) mit einer zweiten Leitfähigkeitsart ausgestattet ist, wobei die Schacht (102) sowohl auf der ersten Oberfläche (101a) als auch auf der zweiten Oberfläche (101b) des Substrats (101) freiliegt,
° mindestens zwei Anschlüsse (1, 2) auf der ersten Oberfläche (101a) des Substrats (101), die mit der Schacht (102) in Kontakt stehen, und mindestens zwei Anschlüsse (3, 4) auf der zweiten Oberfläche (101b) des Substrats (101), die ebenfalls mit der Schacht (102) in Kontakt stehen, wobei die mindestens zwei Anschlüsse (3, 4) auf der zweiten Oberfläche (101b) des Substrats (101) mit einer orthogonalen Projektion auf das Substrat (101) unterhalb der mindestens zwei Anschlüsse (1, 2) auf der ersten Oberfläche (101a) des Substrats (101) angeordnet sind,
° eine dielektrische Schicht (104), die auf der ersten Oberfläche (101a) des Substrats (101) angeordnet ist;
° eine von der dielektrischen Schicht (104) umschlossene Verdrahtung (105, 106, 107, 108); und
° einen mit leitfähigem Füllmaterial (305) gefüllten Silizium-Durchgang (TSV), der einen vertikalen Leiterpfad durch das Substrat (101) zur Verbindung des dritten und vierten Anschlusses (3, 4) mit der Verdrahtung in der dielektrischen Schicht (104) bereitstellt.

2. Vertikales Hall-Element nach Anspruch 1,
° wobei die mindestens zwei Anschlüsse (1, 2) auf der ersten Oberfläche (101a) des Substrats (101) einen ersten Anschluss (1) und einen zweiten Anschluss (2) umfassen, die nebeneinander auf der ersten Oberfläche (101a) des Substrats (101) angeordnet sind,
° wobei die mindestens zwei Anschlüsse (3, 4) auf der zweiten Oberfläche (101b) des Substrats (101) einen dritten Anschluss (3) und einen vierten Anschluss (4) umfassen, die nebeneinander auf der zweiten Oberfläche (101b) des Substrats (101) angeordnet sind,
° wobei der vierte Anschluss (4) direkt unterhalb des ersten Anschlusses (1) angeordnet ist, so dass eine gedachte Gerade zwischen einem Mittelpunkt des ersten Anschlusses (1) und einem Mittelpunkt des vierten Anschlusses (4) senkrecht zur ersten und zweiten Oberfläche (101a, 101b) des Substrats (101) verläuft,
° wobei der dritte Anschluss (3) direkt unterhalb des zweiten Anschlusses (2) angeordnet ist, so dass eine gedachte Gerade zwischen dem Mittelpunkt des zweiten Anschlusses (2) und dem Mittelpunkt des dritten Anschlusses (3) senkrecht zur ersten und zweiten Oberfläche (101a, 101b) des Substrats (101) verläuft.

3. Vertikales Hall-Element nach Anspruch 1 oder 2, wobei jeder der mindestens zwei Anschlüsse (1, 2) auf der ersten Oberfläche (101a) des Substrats (101) eine flache, hochdotierte Zone (103) aufweist, die sich von der ersten Oberfläche (101a) in das Substrat (101) erstreckt und wobei die hochdotierte Zone die Leitfähigkeit des zweiten Typs aufweist.

4. Vertikales Hall-Element nach einem der vorhergehenden Ansprüche, wobei die mindestens zwei Anschlüsse (1, 2) auf der ersten Oberfläche (101a) des Substrats (101) mit einer ersten Metallschicht (106) der Verdrahtung verbunden sind, die in die dielektrische Schicht (104) eingebettet ist.

5. Vertikales Hall-Element nach einem der vorhergehenden Ansprüche, umfassend: ein Trägersubstrat (201), das mit einer Oberfläche (104a) der dielektrischen Schicht (104) verbunden ist, wobei die Oberfläche (104a) der dielektrischen Schicht (104) einer Oberfläche der dielektrischen Schicht auf der ersten Oberfläche (101a) des Substrats (101) gegenüberliegt.

6. Vertikales Hall-Element nach einem der Vorhergehenden Ansprüche, wobei jeder der mindestens zwei Anschlüsse (3, 4) auf der zweiten Oberfläche (101b) des Substrats (101) eine flache, hochdotierte Zone (303) aufweist, die sich von der zweiten Oberfläche (101b) in das Substrat (101) erstreckt, wobei die hochdotierte Zone (303) die Leitfähigkeit des zweiten Typs aufweist.

7. Vertikales Hall-Element nach Anspruch 6, umfassend:
∘ eine zweite dielektrische Schicht (304),
∘ eine Passivierungsschicht (306),
∘ wobei die zweite dielektrische Schicht (304) auf der zweiten Oberfläche (101b) des Substrats (101) angeordnet ist und die Passivierungsschicht (308) auf der dielektrischen Schicht (304) angeordnet ist.

8. Vertikales Hall-Element nach einem der vorhergehenden Ansprüche, wobei das leitfähige Füllmaterial (305) der Silizium-Durchgangsbohrung (TSV) durch eine dielektrische Beschichtung (306), die auf einer Innenfläche der Silizium-Durchgangsbohrung (TSV) angeordnet ist, vom Substrat (101) isoliert ist.

9. Vertikales Hall-Element nach einem der vorhergehenden Ansprüche, umfassend: eine Tiefengraben-Isolationsstruktur (601), die sich von der ersten Oberfläche (101a) des Substrats (100) bis zur zweiten Oberfläche (101b) des Substrats erstreckt, so dass die Schacht (102) durch die Tiefengraben-Isolationsstruktur (601) vom Substrat (101) isoliert ist.

10. Vertikales Hall-Element nach einem der vorhergehenden Ansprüche, wobei das vertikale Hall-Element als kreisförmiges vertikales Hall-Element ausgebildet ist, wobei die Schacht (102) als ringförmige Schacht ausgebildet ist, wobei das vertikale Hall-Element mehrere von mindestens zwei Anschlüssen (1, 2, ..., N) aufweist, die auf der ersten Oberfläche (101a) des Substrats (101) auf einem ersten Kreis angeordnet sind und mit der Schacht (102) in Kontakt stehen, und mehrere von mindestens zwei Anschlüssen (1', 2', ..., N') aufweisen, die auf der zweiten Oberfläche (101b) des Substrats (101) auf einem zweiten Kreis angeordnet sind und mit der Schacht (102) in Kontakt stehen, wobei jeder der mehreren Anschlüsse (1', 20, ..., N') auf der zweiten Oberfläche (101b) des Substrats (101) in orthogonaler Projektion auf das Substrat (101) unter einem der mehreren Anschlüsse (1, 2, ..., N) auf der ersten Oberfläche (101a) des Substrats (101) angeordnet ist.

11. Vertikales Hall-Element nach Anspruch 10, umfassend: zwei ringförmige Isolationsstrukturen (301a, 301b), wobei sich die beiden ringförmigen Isolationsstrukturen (301a, 301b) von der ersten Oberfläche (101a) des Substrats (101) zur zweiten Oberfläche (101b) des Substrats (101) erstrecken und konzentrisch zur ringförmigen Schacht (102) angeordnet sind, so dass die Schacht (102) seitlich von den beiden ringförmigen Isolationsstrukturen (301a, 301b) umschlossen und vom Substrat (101) isoliert ist.

12. Halbleitervorrichtung, umfassend:
∘ das vertikale Hall-Element nach einem der Ansprüche 1 bis 11,
∘ eine Schaltung zum Betrieb des vertikalen Hall-Elements, wobei die Schaltung als integrierter Schaltkreis im Substrat (101) ausgebildet ist.

13. Halbleitervorrichtung nach Anspruch 12,
∘ wobei die Schaltung Folgendes umfasst:
∘ ein Bondpad (309), ausgebildet auf der zweiten Oberfläche (101b) des Substrats (101),
∘ eine Silizium-Durchgangsbohrung (311) zur Verbindung des Bondpads (309) mit einer in der dielektrischen Schicht (104) auf der ersten Oberfläche (101a) des Substrats (101) angeordneten Leitung (106b).

## Revendications

1. Élément Hall vertical (100, 200, 300, 400, 500, 600, 700), comprenant:
° un substrat (101) d'un premier type de conductivité avec une première surface (101a) et une deuxième surface (101b);
° un puits (102) disposé dans le substrat (101), le puits (102) présentant un deuxième type de conductivité, dans lequel le puits (102) est exposé à la fois sur la première surface (101a) et sur la deuxième surface (101b) du substrat (101),
° au moins deux bornes (1, 2) arrangées sur la première surface (101a) du substrat (101) et en contact avec le puits (102), et au moins deux bornes (3, 4) arrangées sur la deuxième surface (101b) du substrat (101) et en contact avec le puits (102), dans lequel au moins deux bornes (3, 4) sur la deuxième surface (101b) du substrat (101) sont disposées avec une projection orthogonale sur le substrat (101) au-dessous des au moins deux bornes (1, 2) sur la première surface (101a) du substrat (101),
° une couche diélectrique (104) disposée sur la première surface (101a) du substrat (101);
° un câblage (105, 106, 107, 108) intégré dans la couche diélectrique (104), et
° un passage traversant en silicium (TSV) rempli avec un matériau de remplissage conducteur (305) qui produit un parcours conducteur vertical à travers le substrat (101) pour la connexion à la fois de la troisième et de la quatrième borne (3, 4) au câblage dans la couche diélectrique (104).

2. Elément Hall vertical selon la revendication 1,
° dans lequel les au moins deux bornes (1, 2) sur la première surface (101a) du substrat (101) comprennent une première borne (1) et une deuxième borne (2) disposées côte à côte sur la première surface (101a) du substrat (101),
° dans lequel les au moins deux bornes (3, 4) sur la deuxième surface (101b) du substrat (101) comprennent une troisième borne (3) et une quatrième borne (4) disposées côte à côte sur la deuxième surface (101b) du substrat (101),
° dans lequel la quatrième borne (4) est située directement sous la première borne (1) de sorte que une ligne droite virtuelle entre un centre de la première borne (1) et un centre de la quatrième borne (4) soit perpendiculaire aux première et deuxième surfaces (101a, 101b) du substrat (101),
° dans lequel la troisième borne (3) est située directement sous la deuxième borne (2) de telle sorte qu'une ligne droite virtuelle entre un centre de la deuxième borne (2) et un centre de la troisième borne (3) soit perpendiculaire à la première et à la deuxième surface (101a, 101b) du substrat (101).

3. Elément Hall vertical selon la revendication 1 ou 2, dans lequel chacune des au moins deux bornes (1, 2) sur la première surface (101a) du substrat (101) comprend une région peu profonde et fortement dopée (103) s'étendant de la première surface (101a) dans le substrat (101), la région fortement dopée (103) présentant le deuxième type de conductivité.

4. Elément Hall vertical selon l'une quelconque des revendications précédentes, dans lequel les au moins deux bornes (1, 2) sur la première surface (101a) du substrat (101) sont connectées à une première couche métallique (106) du câblage intégré dans la couche diélectrique (104).

5. Elément Hall vertical selon l'une quelconque des revendications précédentes, comprenant : un substrat porteur (201) lié à une surface supérieure (104a) de la couche diélectrique (104), ladite surface supérieure (104a) de la couche diélectrique (104) étant opposée à une surface de la couche diélectrique disposée sur la première surface (101a) du substrat (101).

6. Elément Hall vertical selon l'une quelconque des revendications précédentes, dans lequel chacune des au moins deux bornes (3, 4) sur la deuxième surface (101b) du substrat (101) comprend une région peu profonde et fortement dopée (303) s'étendant de la deuxième surface (101b) dans le substrat (101), la région fortement dopée (303) présentant le deuxième type de conductivité.

7. Elément Hall vertical selon la revendication 6, comprenant :
∘ une deuxième couche diélectrique (304),
∘ une couche de passivation (308),
∘ la deuxième couche diélectrique (304) étant disposée sur la deuxième surface (101b) du substrat (101) et la couche de passivation (308) étant disposée sur la couche diélectrique (304).

8. Elément Hall vertical selon l'une quelconque des revendications précédentes, dans lequel le matériau de remplissage conducteur (305) du passage traversant en silicium (TSV) est isolé du substrat (101) par un revêtement diélectrique (306) disposé sur une surface interne du passage traversant en silicium (TSV).

9. Elément Hall vertical selon l'une quelconque des revendications précédentes, comprenant : une structure d'isolation profonde à tranchée (601) s'étendant de la première surface (101a) du substrat (100) à la deuxième surface (101b) du substrat, de sorte que le puits (102) soit isolé du substrat (101) par la structure d'isolation profonde à tranchée (601).

10. Elément Hall vertical selon l'une quelconque des revendications précédentes, dans lequel l'élément Hall vertical est configuré comme un élément Hall vertical circulaire, le puits (102) étant formé comme un puits annulaire, l'élément Hall vertical comportant une pluralité d'au moins deux bornes (1, 2, ... , N) situées sur la première surface (101a) du substrat (101) sur un premier cercle et en contact avec le puits (102), et une pluralité d'au moins deux bornes (1', 2', ... , N') situées sur la deuxième surface (101b) du substrat (101) sur un deuxième cercle et en contact avec le puits (102), dans lequel chacune des pluralités d'au moins deux bornes (1', 2', ... , N') sur la deuxième surface (101b) du substrat (101) est disposée en projection orthogonale sur le substrat (101) sous l'une de la pluralité d'au moins deux bornes (1, 2, ... , N) sur la première surface (101a) du substrat (101).

11. Elément Hall vertical selon la revendication 10, comprenant : deux structures d'isolation annulaires (301a, 301b), les deux structures d'isolation annulaires (301a, 301b) s'étendant de la première surface (101a) du substrat (101) à la deuxième surface (101b) du substrat (101), et étant concentriques au puits annulaire (102), de sorte que le puits (102) soit latéralement entouré par les deux structures d'isolation annulaires (301a, 301b) et isolé du substrat (101).

12. Dispositif semi-conducteur, comprenant :
∘ l'élément Hall vertical selon l'une quelconque des revendications 1 à 11,
∘ un circuit de commande de l'élément Hall vertical, le circuit étant configuré comme un circuit intégré formé dans le substrat (101).

13. Dispositif semi-conducteur selon la revendication 12,
∘ dans lequel le circuit comprend :
∘ une pastille de connexion (309) formée sur la deuxième surface (101b) du substrat (101),
∘ un passage traversant en silicium (311) assurant une connexion entre la pastille de connexion (309) et un câblage (106b) disposé dans la couche diélectrique (104) sur la première surface (101a) du substrat (101).
